# EUROPEAN PATENT APPLICATION

(11) **EP 3 460 829 A1**
(43) Date of publication of application: **27.03.2019**
(21) Application number: 18183674.3
(22) Date of filing: 16.07.2018
(51) Int. Cl.: H01L 21/04, H01L 29/66

(54) **METHOD FOR MANUFACTURING SEMICONDUCTOR DEVICE**

(30) Priority: 22.09.2017 JP 2017182522
(71) Applicant: Renesas Electronics Corporation, 135-0061 Tokyo (JP)
(72) Inventor: FUJII, Yuji, Hitachinaka-shi, Ibaraki 312-8504 (JP); HISADA, Kenichi, Hitachinaka-shi, Ibaraki 312-8504 (JP); YAMASHITA, Yasunori, Hitachinaka-shi, Ibaraki 312-8504 (JP)
(74) Representative: Mewburn Ellis LLP

(57) **Abstract**

A method for manufacturing a semiconductor device includes the steps of forming a metal film (Ni film) over the bottom surface of a contact hole that exposes a portion including SiC at the bottom surface, and performing a heat treatment to form a silicide film at the bottom surface of the contact hole by a silicidation reaction of the metal film MT and the portion including SiC. Also, the heat treatment step is a step of irradiating a laser beam on the surface of a SiC substrate. As the heat treatment, annealing is performed using the laser beam that goes through SiC and is absorbed by metal (Ni and the like).

## Description

### CROSS-REFERENCE TO RELATED APPLICATIONS

The disclosure of Japanese Patent Application No.2017-182522 filed on September 22, 2017 including the specification, drawings and abstract is incorporated herein by reference in its entirety.

### BACKGROUND

The present invention relates to a method for manufacturing a semiconductor device, and can be utilized suitably for a semiconductor device that uses a silicon carbide (SiC) substrate in particular.

In a semiconductor device using a transistor, semiconductor devices using a SiC substrate have been studied. For example, in a power transistor, when a SiC substrate is used, because the band gap of SiC is larger than that of silicon (Si), the dielectric breakdown voltage increases. Also, over a semiconductor element such as a transistor, a plug (via) is arranged for electric coupling with wiring and the like, and there is a case that a silicide film is formed over the bottom surface of the plug for the purpose of reducing the coupling resistance.

For example, in Japanese Unexamined Patent Application Publication No. 2013-211467, a method for manufacturing a silicon carbide semiconductor element is disclosed. Also, there is disclosed a technology for preventing exfoliation of the back surface electrode possibly occurring at the time of wafer dicing and picking up after formation of the back surface electrode including Ni₂Si and deposited TiC over Ni₂Si.

Also, in Japanese Unexamined Patent Application Publication No. 2011-146622, there is disclosed a silicon carbide semiconductor device including an ohmic electrode preventing oxidation of a nickel silicide film and having excellent ohmic contact.

### SUMMARY

The present inventors are engaged in R&D of a semiconductor device that uses a silicon carbide (SiC) substrate, and are intensively studying on improvement of the characteristics of the semiconductor device.

Also, during the course of the R&D of a semiconductor device that uses a silicon carbide (SiC) substrate, as described below, the present inventors faced a problem of increase of the contact resistance between a part of a semiconductor element including SiC and an electro-conductive film (plug, via) arranged within a contact hole over the semiconductor element.

Further, as a result of intensive study to solve the problem, the present inventors came to know that the cause of the increase of the contact resistance was segregation of carbon (C) from the SiC substrate in the contact section, and came to find out a method for forming a silicide film capable of reducing segregation of carbon (C).

Other objects and new features will be clarified from the description of the present specification and the attached drawings.

Followings are brief descriptions of the summary of a representative one among the embodiments disclosed in the present application.

A method for manufacturing a semiconductor device shown in an embodiment disclosed in the present application includes the steps of forming a metal film containing a first metal over the bottom surface of a contact hole that exposes a portion including SiC at the bottom surface, and performing a heat treatment to form a silicide film of the first metal at the bottom surface of the contact hole by a silicidation reaction of the metal film and a portion including the SiC. Also, the heat treatment step is a step of irradiating a laser beam on a first surface side of a SiC substrate.

According to a method for manufacturing a semiconductor device shown in a representative embodiment shown below disclosed in the present application, a semiconductor device with excellent characteristics can be manufactured.

### BRIEF DESCRIPTION OF THE DRAWINGS

FIG. 1 is a cross-sectional view that shows a configuration of a semiconductor device of the first embodiment.
FIG. 2 is a plan view that shows a configuration of the semiconductor device of the first embodiment.
FIG. 3 is a plan view that shows a configuration of the semiconductor device of the first embodiment.
FIG. 4 is a cross-sectional view that shows a step for manufacturing the semiconductor device of the first embodiment.
FIG. 5 is a cross-sectional view that shows a step for manufacturing the semiconductor device of the first embodiment.
FIG. 6 is a cross-sectional view that shows a step for manufacturing the semiconductor device of the first embodiment.
FIG. 7 is a cross-sectional view that shows a step for manufacturing the semiconductor device of the first embodiment.
FIG. 8 is a cross-sectional view that shows a step for manufacturing the semiconductor device of the first embodiment.
FIG. 9 is a cross-sectional view that shows a step for manufacturing the semiconductor device of the first embodiment.
FIG. 10 is a cross-sectional view that shows a step for manufacturing the semiconductor device of the first embodiment.
FIG. 11 is a cross-sectional view that shows a step for manufacturing the semiconductor device of the first embodiment.
FIG. 12 is a cross-sectional view that shows a step for manufacturing the semiconductor device of the first embodiment.
FIG. 13 is a cross-sectional view that shows a step for manufacturing the semiconductor device of the first embodiment.
FIG. 14 is a cross-sectional view that shows a step for manufacturing the semiconductor device of the first embodiment.
FIG. 15 is a cross-sectional view that shows a step for manufacturing the semiconductor device of the first embodiment.
FIG. 16 is a plan view that shows a wafer including a SiC substrate.
FIG. 17A is a plan view that shows the shots of the laser irradiated successively.
FIG. 17B is a plan view that shows the shots of the laser irradiated successively.
FIG. 18 is a drawing that shows a waveform of a laser of the double pulse type.
FIG. 19A is a drawing that shows an example of the laser irradiation condition.
FIG. 19B is a drawing that shows the relation between the overlapping rate of a laser and the contact resistance.
FIG. 20 is a cross-sectional view that shows a step for manufacturing a semiconductor device of a comparative example.
FIG. 21 is a cross-sectional view that shows a step for manufacturing the semiconductor device of the comparative example.
FIG. 22 is a cross-sectional view that shows a step for manufacturing the semiconductor device of the comparative example.
FIG. 23 is a cross-sectional view that shows a step for manufacturing the semiconductor device of the comparative example.
FIG. 24 is a cross-sectional view that shows a step for manufacturing the semiconductor device of the comparative example.
FIG. 25 is a cross-sectional view that shows a step for manufacturing the semiconductor device of the comparative example.
FIG. 26 is a cross-sectional view that shows a step for manufacturing the semiconductor device of the comparative example.
FIG. 27 is a cross-sectional view that shows a step for manufacturing a semiconductor device of the second embodiment.
FIG. 28 is a cross-sectional view that shows a step for manufacturing the semiconductor device of the second embodiment.
FIG. 29 is a cross-sectional view that shows a step for manufacturing the semiconductor device of the second embodiment.
FIG. 30 is a cross-sectional view that shows a step for manufacturing the semiconductor device of the second embodiment.
FIG. 31 is a cross-sectional view that shows a step for manufacturing the semiconductor device of the second embodiment.
FIG. 32 is a cross-sectional view that shows a step for manufacturing the semiconductor device of the second embodiment.
FIG. 33 is a cross-sectional view that shows a step for manufacturing the semiconductor device of the second embodiment.
FIG. 34 is a cross-sectional view that shows a step for manufacturing a semiconductor device of the third embodiment.
FIG. 35 is a cross-sectional view that shows a step for manufacturing the semiconductor device of the third embodiment.
FIG. 36 is a cross-sectional view that shows a step for manufacturing the semiconductor device of the third embodiment.
FIG. 37 is a cross-sectional view that shows a step for manufacturing the semiconductor device of the third embodiment.
FIG. 38 is a cross-sectional view that shows a step for manufacturing the semiconductor device of the third embodiment.
FIG. 39 is a cross-sectional view that shows a step for manufacturing the semiconductor device of the third embodiment.
FIG. 40 is a cross-sectional view that shows a step for manufacturing the semiconductor device of the third embodiment.

### DETAILED DESCRIPTION

In embodiments described below, although explanation will be made separately in plural sections or embodiments when it is required for the purpose of convenience, they are not unrelated to each other and are in relationship that one is a modification, application, detailed explanation, supplementary explanation and the like of a part or the total of the other unless otherwise stated explicitly. Also, in embodiments described below, when a number and the like (inclusive of the number of pieces, numerical value, amount, scope, and the like) of an element are mentioned, the embodiment is not limited to the specific number and may be equal to or greater than the specific number or may be equal to or less than the specific number with the exception of a case stated explicitly in particular, a case apparently limited to a specific number in principle, and so on.

Further, in embodiments described below, the configuration elements (inclusive of the element step and the like) of the embodiment are not necessarily indispensable with the exception of a case stated explicitly in particular, a case considered to be apparently indispensable in principle, and so on. In a similar manner, in embodiments described below, when the shape, positional relation, and the like of a configuration element and the like are mentioned, those substantially approximate or similar to the shape and the like and so on are to be included with the exception of a case stated explicitly in particular, a case apparently not considered to be the case in principle, and so on. The same applies also to the number and the like described above (inclusive of the number of pieces, numerical value, amount, scope, and the like).

Below, embodiments will be explained in detail based on the drawings. Also, in all drawings for explaining the embodiments, members having a same function are marked with a same or related reference sign, and repeated explanation for them will be omitted. Further, when plural similar members (portions) exist, there is a case a symbol is added to the reference sign of a collective term to show an individual or specific portion. Furthermore, in embodiments described below, explanation of a same or similar portion will not be repeated in principle unless it is particularly necessary.

Also, in the drawings used in embodiments, there is also a case of omitting hatching even in a cross-sectional view in order to easily understand the drawing. Further, there is also a case of adding hatching even in a plan view in order to easily understand the drawing.

Also, in cross-sectional views and plan views, there is a case that the size of each portion does not correspond to the actual device and a specific portion is displayed relatively large in order to easily understand the drawing. Further, even when a cross-sectional view and a plan view correspond to each other, there is a case that a specific portion is displayed relatively large in order to easily understand the drawing.

### (First embodiment)

### [Explanation of structure]

Below, a semiconductor device of the present embodiment will be explained in detail using the drawings.

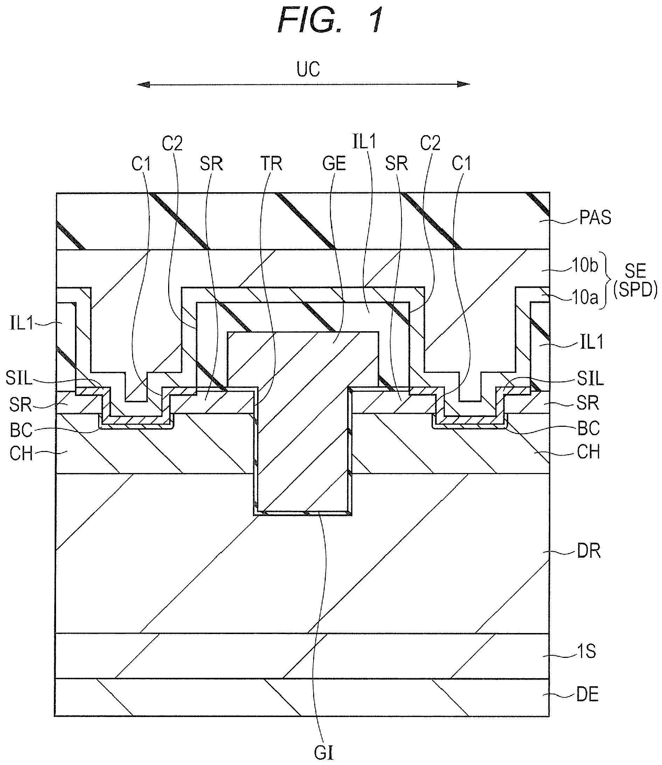

FIG. 1 is a cross-sectional view that shows a configuration of a semiconductor device of the present embodiment. The semiconductor device shown in FIG. 1 includes a transistor (element). To be more specific, the semiconductor device of the present embodiment includes a power transistor of the trench gate type. Such transistor is also called "power MOSFET" and "IGBT" for example.

As shown in FIG. 1, the semiconductor device of the present embodiment includes a drift layer (drain region) DR arranged on the surface (the first surface) side of a SiC substrate 1S, a channel layer CH arranged over the drift layer DR, and a source region SR arranged over the channel layer CH. The drift layer DR is configured of an n-type semiconductor region, the channel layer CH is configured of a p-type semiconductor region, and the source region SR is configured of an n-type semiconductor region. These semiconductor regions include SiC, the p-type semiconductor region includes p-type impurities, and the n-type semiconductor region includes n-type impurities. Also, as described below, these semiconductor regions can include an n-type or p-type epitaxial layer.

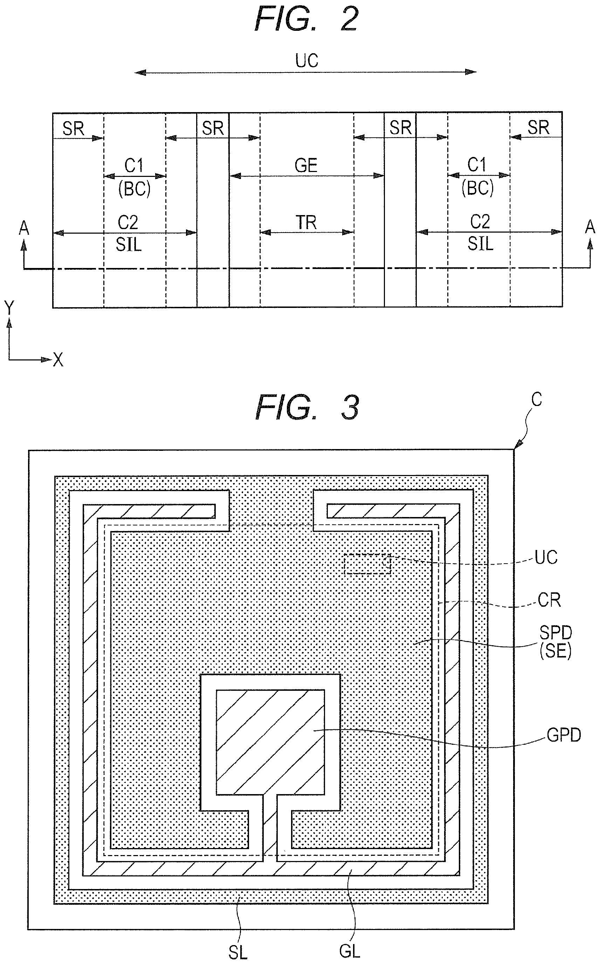

Also, the semiconductor device of the present embodiment includes a gate electrode GE disposed within a trench TR through a gate insulation film GI, the trench TR penetrating the source region SR and the channel layer CH and reaching the drift layer DR. This gate electrode GE fills the inside of the trench TR and extends so as to overlap with a part over the source region SR in a plan view (refer to FIG. 2), and the cross section of the gate electrode GE has a "T-shape". There is a case that the structure of such gate electrode GE is referred to as a "T-gate structure".

Also, at the other ends on the opposite side of one end of the source region SR contacting the trench TR, contact holes (C1, C2) reaching the channel layer CH are arranged. Here, with respect to the contact holes (C1, C2), there is a case that a portion with a larger width is made the contact hole C2 and a portion with a smaller width is made the contact hole C1. Also, at the bottom surface of the contact holes (C1, C2), body contact regions BC are formed. The body contact region BC is configured of a p-type semiconductor region having higher impurities density compared to the channel layer CH, and is formed to secure the ohmic contact between a source electrode SE and the channel layer CH.

Also, over the gate electrode GE, an interlayer dielectric film IL1 is arranged. The interlayer dielectric film IL1 includes an insulation film such as a silicon oxide film. Also, over the interlayer dielectric IL1 and inside the contact holes (C1, C2), the source electrode SE is arranged. The source electrode SE includes an electro-conductive film. Further, out of the source electrode SE, there is a case that a portion positioned inside the contact holes (C1, C2) is deemed a plug (via), and a portion extending over the interlayer dielectric film IL1 is deemed wiring. Also, here, the source electrode SE includes a laminated film of a first electro-conductive film 10a that is a lower layer film and a second electro-conductive film 10b that is an upper layer film. This source electrode SE is electrically coupled with the body contact region BC and the source region SR. Over the source electrode SE, a surface protection film PAS including an insulation film is formed. Also, on the back surface (second surface) side of the SiC substrate 1S, a drain electrode DE is formed.

Here, the source electrode SE and the body contact region BC are coupled with each other through a silicide film SIL. Also, the source electrode SE and the source region SR are coupled with each other through the silicide film SIL. By this silicide film SIL, the contact resistance between the source electrode SE and the body contact region BC can be reduced, and the contact resistance between the source electrode SE and the source region SR can be reduced.

Also, in the semiconductor device of the present embodiment, because laser anneal is used in a heat treatment step in forming a silicide film as explained below in detail, formation of a carbon layer by segregation of carbon (C) within SiC can be suppressed. Thus, increase of the contact resistance and contact failure caused by segregation of carbon (C) within the SiC substrate can be suppressed, and excellent contact between the transistor (the source region SR here) and the source electrode SE can be effected.

### <Operation>

In the semiconductor device (transistor) of the present embodiment, when a gate voltage equal to or greater than a threshold voltage is applied to the gate electrode GE, an inversion layer (n-type semiconductor region) is formed in the channel layer (n-type semiconductor region) CH that contacts the side surface of the trench TR. Also, the source region SR and the drift layer DR come to be electrically coupled with each other by the inversion layer, and, when there is a potential difference between the source region SR and the drift layer DR, electrons flow from the source region SR to the drift layer DR through the inversion layer. In other words, an electric current flows from the drift layer DR to the source region SR through the inversion layer. Thus, the transistor can be turned on.

On the other hand, when voltage lower than the threshold voltage is applied to the gate electrode GE, the inversion layer having been formed in the channel layer CH disappears, and the source region SR and the drift layer DR become nonconductive with each other. Thus, the transistor can be turned off.

As described above, the on/off operation of the transistor is performed by changing the gate voltage applied to the gate electrode GE of the transistor.

### <Planar layout>

The transistor shown in FIG. 1 is disposed repeatedly in a plan view as described below. Therefore, there is a case that the transistor shown in FIG. 1 is called "unit transistor UC". FIG. 2 and FIG. 3 are plan views that show a configuration of the semiconductor device of the present embodiment. FIG. 1 corresponds to A-A cross section of FIG. 2 for example. Also, the region UC shown in FIG. 2 corresponds to the region UC shown in FIG. 3 for example. FIG. 3 shows one chip region C.

As shown in FIG. 2, the planar shape of the gate electrode GE is a rectangular shape having a long side in Y-direction. The planar shape of the trench TR is a rectangular shape having a long side in Y-direction. The width (the length in X-direction) of the gate electrode GE is larger than the width (the length in X-direction) of the trench TR. On both sides of the trench TR, the source regions SR are disposed. The planar shape of the source region SR is a rectangular shape having a long side in Y-direction. Also, on the outer side of the source region SR, the body contact region BC is disposed. The planar shape of the body contact region BC is a rectangular shape having a long side in Y-direction.

The unit transistors UC are repeatedly disposed symmetrically with respect to the center line that extends in Y-direction of the body contact region BC of a rectangular shape.

Over the body contact region BC and a part of the source regions SR on both sides of the body contact region BC shown in FIG. 2, the source electrode SE are disposed through the silicide film SIL as shown in FIG. 1. This source electrode SE is expandingly disposed so as to extend to above the gate electrode GE as shown in FIG. 3. Further, although it is not illustrated in the cross section shown in FIG. 1, over the end of the gate electrode GE, a gate line GL and a gate pad GPD shown in FIG. 3 are disposed through the contact hole (plug, via) not illustrated. The gate line GL and the gate pad GPD can include the electro-conductive films (10a, 10b) that are in the same layer of the source electrode SE.

### [Explanation of manufacturing method]

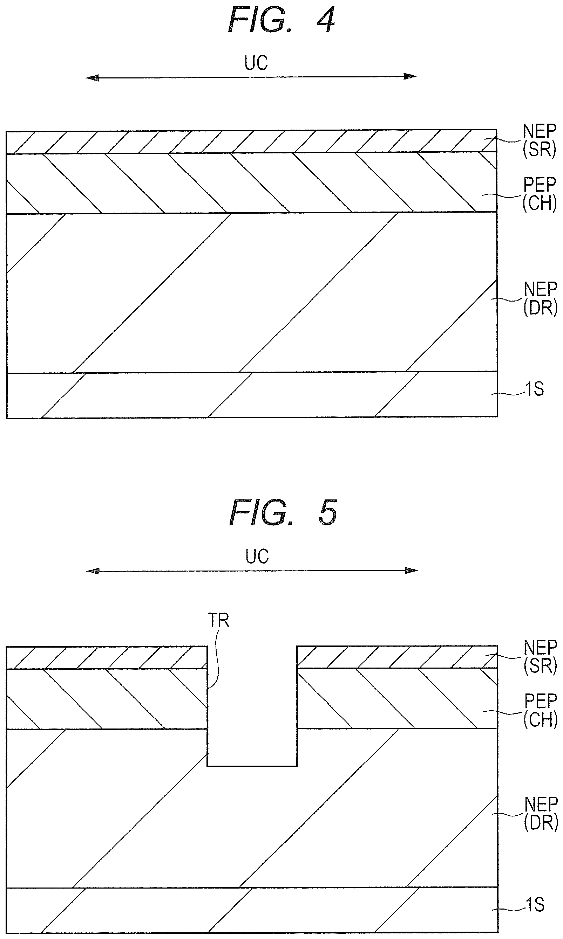

Next, referring to FIG. 4-FIG. 15, a method for manufacturing a semiconductor device of the present embodiment will be explained, and a configuration of the semiconductor device will be further clarified. FIG. 4-FIG. 15 are cross-sectional views that show a step for manufacturing the semiconductor device of the present embodiment.

First, as shown in FIG. 4, the SiC substrate (semiconductor substrate including SiC) 1S where an epitaxial layer is formed is provided. The epitaxial layer is a layer including SiC, and includes three layers of an n-type epitaxial layer NEP, a p-type epitaxial layer PEP, and an n-type epitaxial layer NEP in this order from the bottom. These layers correspond respectively to the n-type semiconductor region, the p-type semiconductor region, and the n-type semiconductor region shown in the column of "explanation of structure".

Although there is no limitation in a method for forming an epitaxial layer to over the SiC substrate 1S, for example, the epitaxial layer can be formed as follows. For example, an epitaxial layer including SiC is made to grow while introducing p-type impurities such as boron (B) and the n-type impurities such as phosphorus (P) or arsenic (As) to over the SiC substrate 1S, and the n-type epitaxial layer NEP is formed. Next, an epitaxial layer including SiC is made to grow while introducing p-type impurities such as boron (B) to over the n-type epitaxial layer NEP, and the p-type epitaxial layer PEP is formed. Then, an epitaxial layer including SiC is made to grow while introducing n-type impurities to over the p-type epitaxial layer PEP, and the n-type epitaxial layer NEP is formed. Thus, the SiC substrate 1S can be formed where the epitaxial layer is formed, the epitaxial layer including three layers of the n-type epitaxial layer NEP, the p-type epitaxial layer PEP, and the n-type epitaxial layer NEP.

The n-type epitaxial layer NEP of the lowest layer becomes the source region SR, the p-type epitaxial layer PEP of the second layer becomes the channel layer CH, and the n-type epitaxial layer NEP of the highest layer becomes the drift layer DR.

Also, the configuration including the SiC substrate 1S and three layers of the n-type epitaxial layer NEP, the p-type epitaxial layer PEP, and the n-type epitaxial layer NEP over the SiC substrate 1S may be regarded a SiC substrate. Further, a semiconductor region corresponding to the n-type epitaxial layer NEP, the p-type epitaxial layer PEP, and the n-type epitaxial layer NEP may be formed by an ion implantation method.

Next, the trench TR is formed as shown in FIG. 5, the trench TR penetrating the n-type epitaxial layer (the source region SR) NEP and the p-type epitaxial layer (the channel layer CH) PEP and reaching the n-type epitaxial layer (the drift layer DR) NEP.

Using a photo lithography technology and an etching technology for example, a hard mask (not illustrated) is formed over the n-type epitaxial layer (the source region SR) NEP, the hard mask having an opening section in the forming region for the trench TR. Next, using this hard mask (not illustrated) as a mask, the n-type epitaxial layer (the source region SR) NEP, the p-type epitaxial layer (the channel layer CH) PEP, and the upper part of the n-type epitaxial layer (the drift layer DR) NEP are etched, and thereby the trench TR is formed. Next, the hard mask (not illustrated) is removed. At the side surface of this trench TR, the n-type epitaxial layer (the drift layer DR) NEP, the p-type epitaxial layer (the channel layer CH) PEP, and the n-type epitaxial layer (the source region SR) NEP are exposed in this order from the bottom. Also, to the bottom surface of this trench TR, the n-type epitaxial layer (the drift layer DR) NEP is exposed.

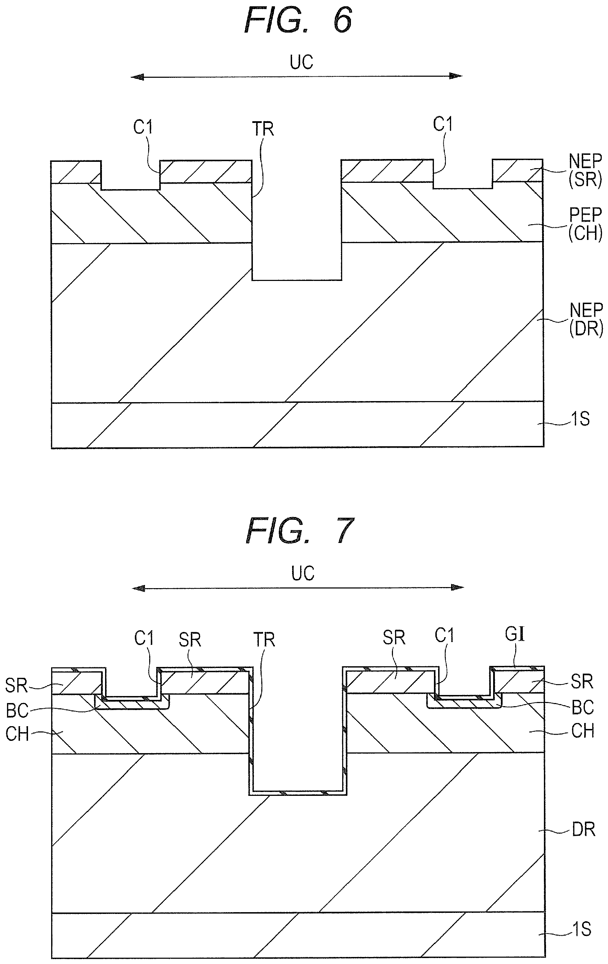

Next, as shown in FIG. 6, in the n-type epitaxial layers (the source region SR) NEP on both sides of the trench TR, the contact holes C1 are formed respectively.

Using a photo lithography technology and an etching technology for example, a hard mask (not illustrated) is formed over the n-type epitaxial layer (the source region SR) NEP, the hard mask having an opening section in the forming region for the contact hole C1. Next, using this hard mask (not illustrated) as a mask, the n-type epitaxial layer (the source region SR) NEP and the upper part of the p-type epitaxial layer (the channel layer CH) PEP are etched, and thereby the contact holes C1 are formed. Next, the hard mask (not illustrated) is removed. To the bottom surface of this contact hole C1, the p-type epitaxial layer (the channel layer CH) PEP is exposed.

Next, as shown in FIG. 7, the body contact region BC is formed below the bottom surface of the contact hole C1. The body contact region BC is formed for example by ion implantation of the p-type impurities into the p-type epitaxial layer (the channel layer CH) PEP exposed to the bottom surface of the contact hole C1 using the hard mask (not illustrated) as a mask. The density of the p-type impurities of this body contact region BC is higher than the density of the p-type impurities of the p-type epitaxial layer (the channel layer CH) PEP.

Next, for example, a silicon oxide film is formed as the gate insulation film GI by the ALD (Atomic Layer Deposition) method and the like over the n-type epitaxial layer (the source region SR) NEP including the inside of the trench TR and the contact hole C1. The gate insulation film GI may be formed by thermal oxidation of the epitaxial layer exposed to the inside of the trench TR. Also, as the gate insulation film GI, other than the silicon oxide film, a high permittivity film such as an aluminum oxide film and a hafnium oxide film may be used which has higher permittivity compared to the silicon oxide film.

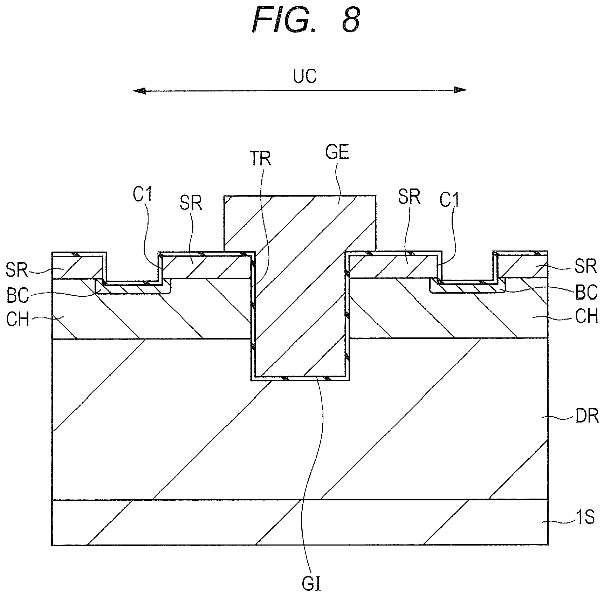

Next, as shown in FIG. 8, the gate electrode GE is formed which is disposed over the gate insulation film GI and has a shape of filling the trench TR. For example, as an electro-conductive film for the gate electrode GE, polycrystalline silicon films are layered by the CVD (Chemical Vapor Deposition) method and the like for example. Next, a photoresist film covering the formation region for the gate electrode GE is formed over the electro-conductive film, and the electro-conductive film is etched using this photoresist film as a mask. Thus, the gate electrode GE is formed.

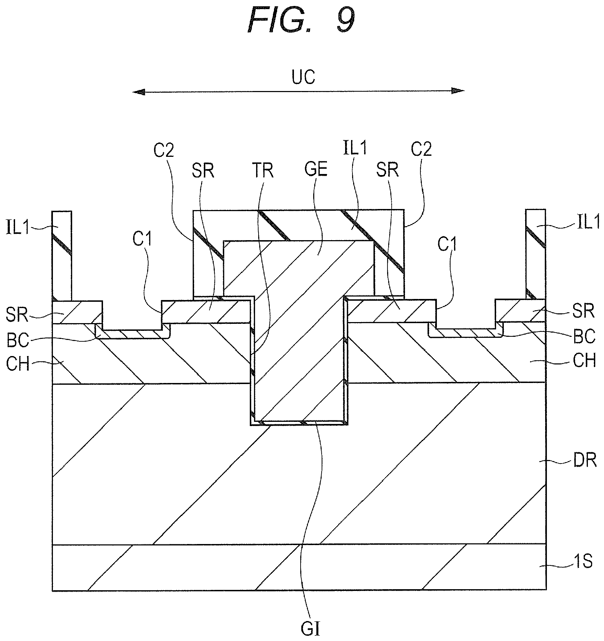

Next, as shown in FIG. 9, the interlayer insulation film IL1 covering the gate electrode GE is formed, and the contact hole C2 is formed.

For example, the silicon oxide films are layered over the body contact region BC, the n-type epitaxial layer (the source region SR) NEP and the gate electrode GE by the CVD method as the interlayer insulation film IL1, the body contact region BC being exposed from the bottom surface of the contact hole C1. Next, a photoresist film (not illustrated) is formed over the interlayer insulation film IL1, the photoresist film having an opening section over the body contact region BC and a part of the source regions SR on both sides of the body contact region BC. Next, the interlayer insulation film IL1 is etched using this photoresist film as a mask, and thereby the contact hole C2 is formed. Below this contact hole C2, the contact hole C1 is positioned. Below these contact holes (C1, C2), the body contact region BC and a part of the source regions SR on both sides of the body contact region BC are exposed.

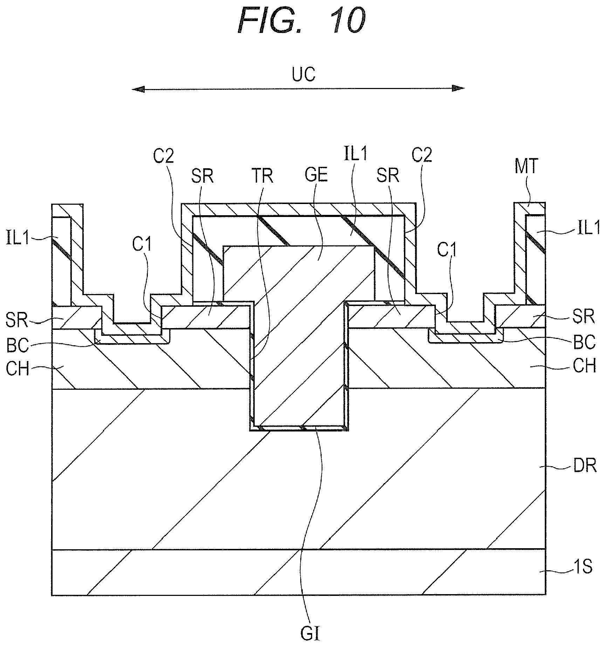

Next, as shown in FIG. 10-FIG. 12, the silicide film SIL is formed over the body contact region BC and a part of the source regions SR on both sides of the body contact region BC (silicidation, silicide process).

First, as shown in FIG. 10, a Ni film for example is formed inside the contact holes (C1, C2) and over the interlayer insulation film IL1 as a metal film (a metal film for a silicide film) MT using the sputtering method and the like. Thereby, portions over the body contact region BC and a part of the source regions SR on both sides of the body contact region BC are covered by the metal film MT. The portion where the silicide film SIL is formed is only a portion where Ni and SiC directly contact with each other (below the contact hole C2, the formation region for the contact hole C2, and the contact region), and the silicide film SIL is formed selectively.

As the metal film MT, a metal film of Ti, W, Mo, Ta, V and the like other than Ni may be used. Also, an alloy film of NiV, NiTi and the like may be used. Further, a layered film of metals of different kinds such as Ni/Ti/Ni may be used.

The film thickness of the metal film (a Ni film here) can be adjusted within a range of 10 nm or more and 100 nm or less for example.

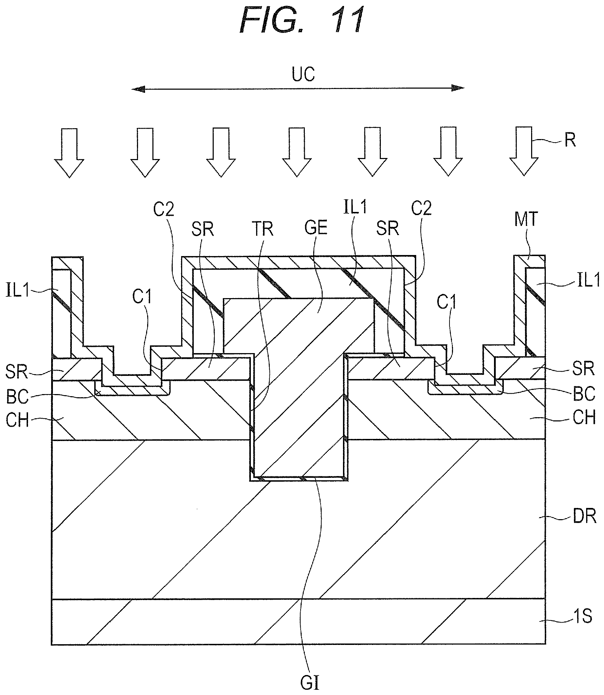

Next, as shown in FIG. 11, laser annealing is performed as a heat treatment. That is, a laser R is irradiated to the SiC substrate 1S. For example, the metal film MT is heated by irradiating the laser R having a pulse with the wavelength of 527 nm to the SiC substrate 1S, and a reaction of the metal and silicon (Si) (silicidation) is caused in the interface of the metal film MT and the SiC substrate (the body contact region BC, the source region SR) 1S. Thereby, the silicide film SIL is formed. Here, the silicide film SIL formed by the heat treatment described above is a NiSi layer for example. Here, the film thickness of the NiSi layer is approximately 30 nm.

Although this laser R having the wavelength of 527 nm is absorbed by the metal film MT, the laser R goes through the SiC substrate (inclusive of the epitaxial layer). Also, when a Si substrate is used instead of the SiC substrate, the laser R having the wavelength of 527 nm is absorbed by both of the metal film MT and the SiC substrate. Thus, by selecting the wavelength of the laser, it is possible that the laser goes through the SiC substrate without raising the temperature of the SiC substrate and is absorbed by the metal film MT to generate the heat. It can be said that a laser going through the SiC substrate and absorbed by the metal film MT is a laser whose energy (hc/λ) is lower than the band gap energy of SiC. Here, although explanation was made exemplifying the laser R having the wavelength of 527 nm, the range of the wavelength of the laser R going through the SiC substrate and absorbed by the metal film MT can be made the range of 455 nm-597 nm. Other than the laser having the wavelength of 527 nm, a laser having the wavelength of 532 nm for example may be used.

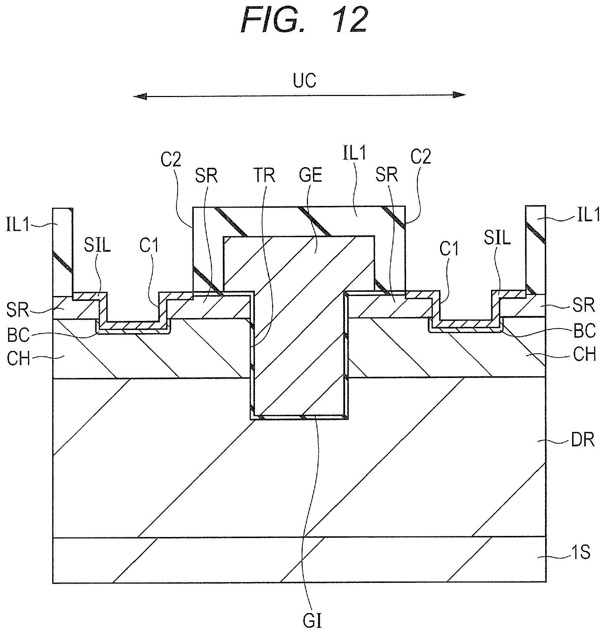

Next, as shown in FIG. 12, unreacted metal film MT is removed. The unreacted metal film MT is removed using a sulfuric acid or SPM (compound liquid of sulfuric acid and hydrogen peroxide solution) and the like for example. Thus, the silicide film SIL is formed over the body contact region BC and a part of the source regions SR on both sides of the body contact region BC.

Thereafter, the interlayer insulation film IL1 over the gate electrode GE not illustrated in the cross section shown in FIG. 12 is removed, and a contact hole (not illustrated) is formed over the gate electrode GE.

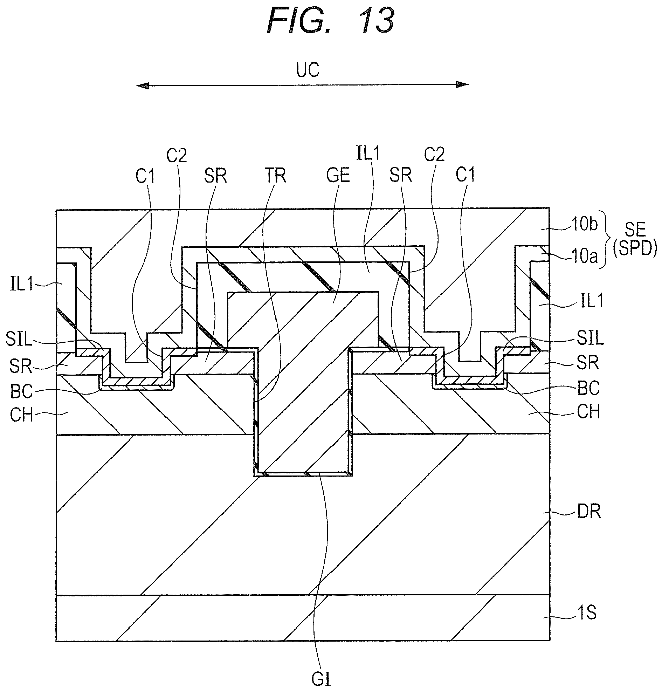

Next, as shown in FIG. 13, the source electrode SE is formed. For example, as shown in FIG. 13, the first electro-conductive film (barrier metal film) 10a is formed inside the contact holes (C1, C2) and over the interlayer insulation film IL1. For example, as the first electro-conductive film 10a, a TiN film is formed by the sputtering method and the like. Next, the second electro-conductive film 10b is formed over the first electro-conductive film 10a. For example, as the second electro-conductive film 10b, an Al film is formed by the sputtering method and the like. Next, by patterning a laminated film of the first electro-conductive film 10a and the second electro-conductive film 10b, the source electrode SE is formed. At this time, the gate line GL and the gate pad GPD not appearing in the cross section of FIG. 13 are formed (refer to FIG. 3).

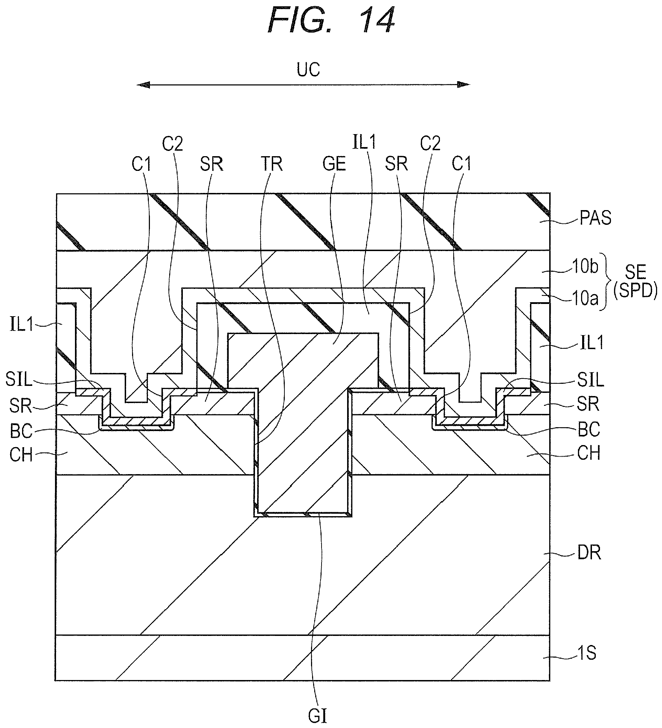

Next, as shown in FIG. 14, the surface protection film PAS is formed so as to cover the source electrode SE, the gate line GL, and the gate pad GPD. For example, silicon oxide films are layered over the source electrode SE and the like as the surface protection film PAS using the CVD method and the like. Also, by patterning the surface protection film PAS, a partial region of the source electrode SE and a partial region of the gate pad GPD are exposed. This exposed section becomes an external coupling region (pad).

Next, the back surface (the second surface) on opposite side of the main surface of the SiC substrate 1S is made the upper surface, the back surface of the SiC substrate 1S is ground, and the SiC substrate 1S is made a thick film.

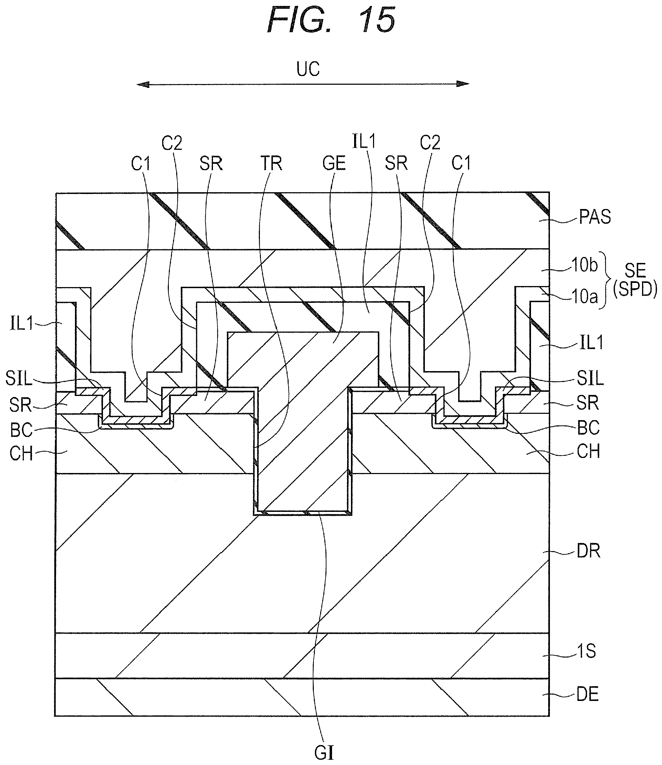

Next, as shown in FIG. 15, the drain electrode DE is formed on the back surface of the SiC substrate 1S. For example, the back surface side of the SiC substrate 1S is made the upper surface, and a metal film is formed. For example, a Ti film, a Ni film, and an Au film are formed successively by the sputtering method. Thus, the drain electrode DE including the metal film can be formed. Also, a silicide film may be formed between the metal film and the SiC substrate 1S.

By the steps described above, the semiconductor device of the present embodiment can be formed.

Thus, according to the present embodiment, because the laser annealing was performed as a heat treatment at the time of forming the silicide film, instantaneous high temperature heating becomes possible, and silicidation can be promoted. Also, with respect to the laser, by selecting such wavelength with which the laser goes through SiC and is absorbed by metal (Ni and the like), the contact section between the SiC substrate and the metal film can be subjected effectively to a heat treatment. For example, unlike RTA described below which is suitable to a heat treatment at a temperature up to approximately 1,000°C, the heating temperature can be made 1,000°C or above, and the excellent silicide film SIL can be formed. For example, when the body contact region BC is made a p-type impurities region, the contact resistance of 1×10⁻⁴ Ωcm² or less can be achieved. Also, when the body contact region BC is made an n-type impurities region, the contact resistance of 1×10⁻⁶ Ωcm² or less can be achieved.

Also, because the laser goes through SiC, a thermal load applied to other portions, for example the SiC substrate below the contact region, is reduced, and segregation of C (carbon) present within the SiC substrate can be suppressed.

On the other hand, in the case of a comparative example using RTA (infrared lamp anneal, Rapid Thermal Anneal) as a heat treatment in forming the silicide film, by segregation of C (carbon) present within the SiC substrate, a thin film of C (carbon) is generated in the contact region, and increase of the contact resistance is caused. Also, the silicide film peels off at the thin film section of C (carbon) to cause a contact failure.

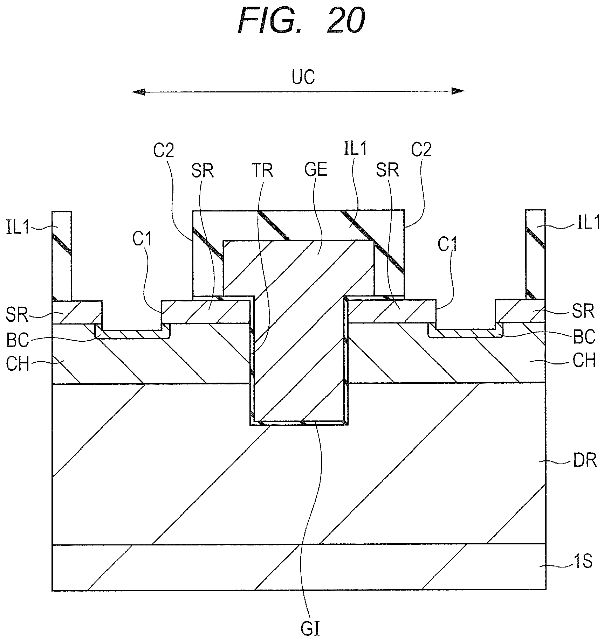

FIG. 20-FIG. 26 are cross-sectional views that show a step for manufacturing a semiconductor device of a comparative example. Below, a method for manufacturing a semiconductor device of a comparative example will be explained referring to the drawings.

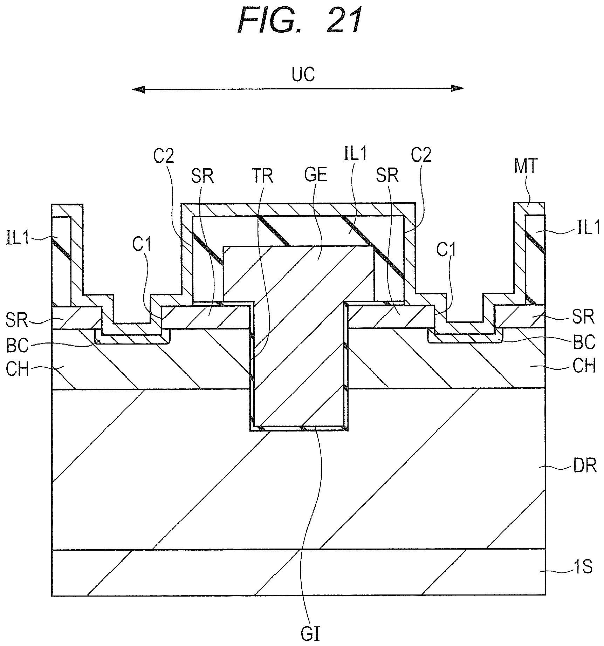

As shown in FIG. 21-FIG. 24, the silicide film SIL is formed over the body contact region BC below the contact holes (C1, C2) of the SiC substrate 1S shown in FIG. 20 and a part of the source regions SR on both sides of the body contact region BC.

First, as shown in FIG. 21, a Ni film, a Ti film, and a Ni film for example are layered successively as the metal film (the metal film for the silicide film) MT inside the contact holes (C1, C2) and over the interlayer insulation film IL1 using the sputtering method and the like. Thus, a portion over the body contact region BC and a part of the source regions SR on both sides of the body contact region BC is covered by the metal film MT (Ni film/Ti film/Ni film). By sandwiching the Ti film within the Ni films thus, segregation of C (carbon) within the SiC substrate can be suppressed.

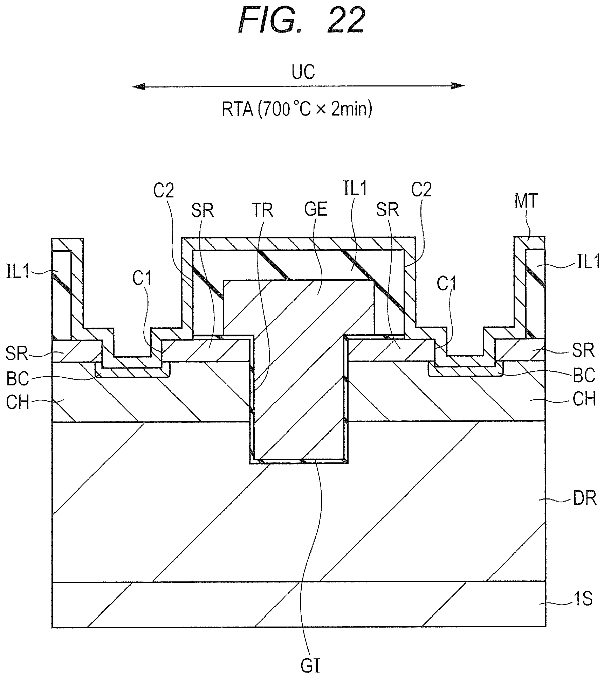

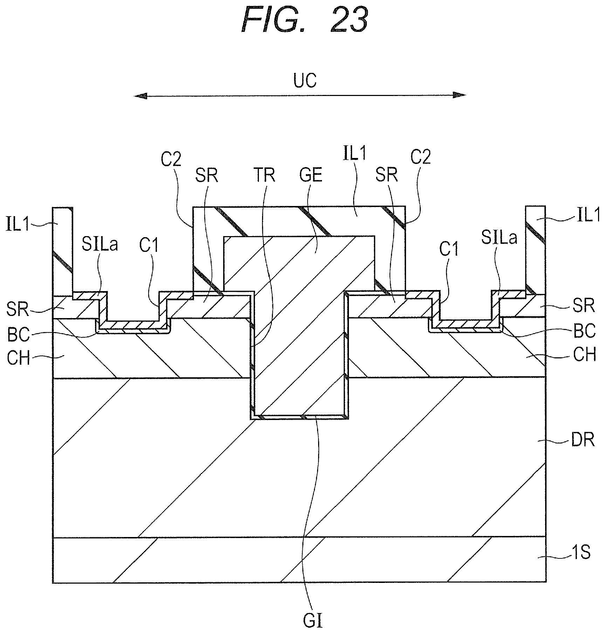

Next, as shown in FIG. 22, the SiC substrate 1S is subjected to the first heat treatment. As the first heat treatment, a heat treatment using RTA is performed. For example, the SiC substrate 1S is subjected to a heat treatment for 2 minutes (min) at approximately 700°C within an inert gas atmosphere. By performing the first heat treatment, a metal-rich silicide film SILa for example is formed. For example, when a three layered film of Ni film/Ti film/Ni film is used as the metal film MT, the silicide film SILa including Ni₂Si is formed (refer to FIG. 23). Also, NiSi becomes a more stable phase compared to this Ni₂Si.

Next, as shown in FIG. 23, the unreacted metal film MT is removed. The unreacted metal film MT is removed using a sulfuric acid or SPM (compound liquid of sulfuric acid and hydrogen peroxide solution) and the like for example. Thus, the silicide film SILa remains over the body contact region BC and a part of the source regions SR on both sides of the body contact region BC.

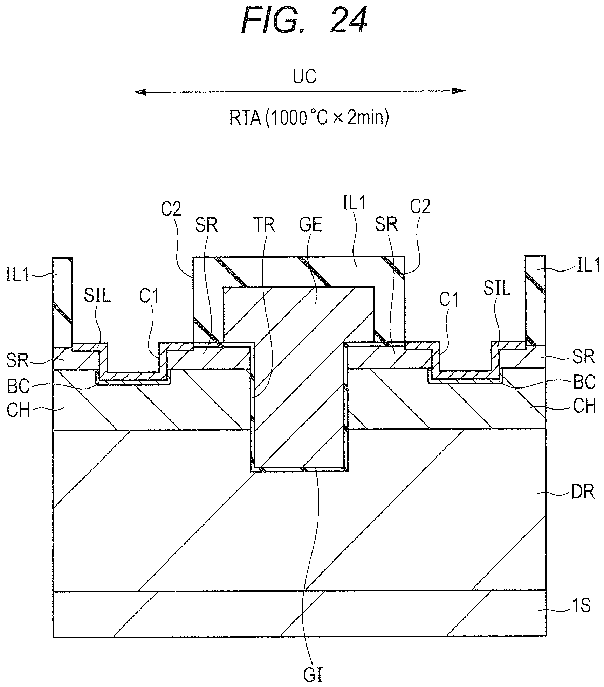

Next, as shown in FIG. 24, the SiC substrate 1S is subjected to the second heat treatment. As the second heat treatment, a heat treatment using RTA is performed. For example, the SiC substrate 1S is subjected to a heat treatment for 2 minutes (min) at approximately 1,000°C within an inert gas atmosphere. For example, by performing the second heat treatment, silicidation progresses, and the metal-rich silicide film SILa becomes the silicon-rich silicide film SIL. In other words, the stoichiometric mixture ratio of metal silicide changes, and the phase of the metal silicide transforms to metal silicide having a higher composition ratio of Si which is in a more stable state. For example, MxSi becomes MySi (x>y). x and y are the composition of M (metal) when Si of the metal silicide is made 1. Here, the silicide film SILa including Ni₂Si becomes the silicide film SIL including NiSi. NiSi is a phase more stable compared to Ni₂Si, and NiSi has high thermal resistance and has higher electro-conductivity compared to Ni₂Si (x=2, y=1).

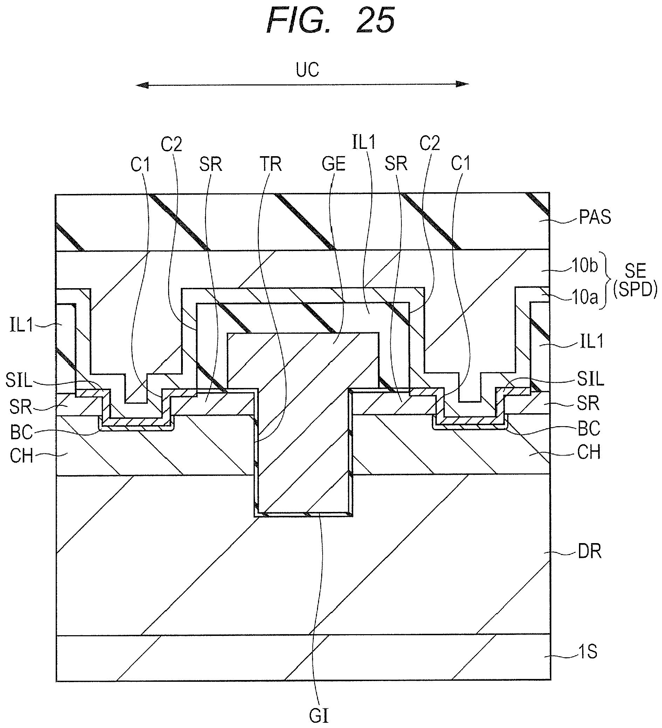

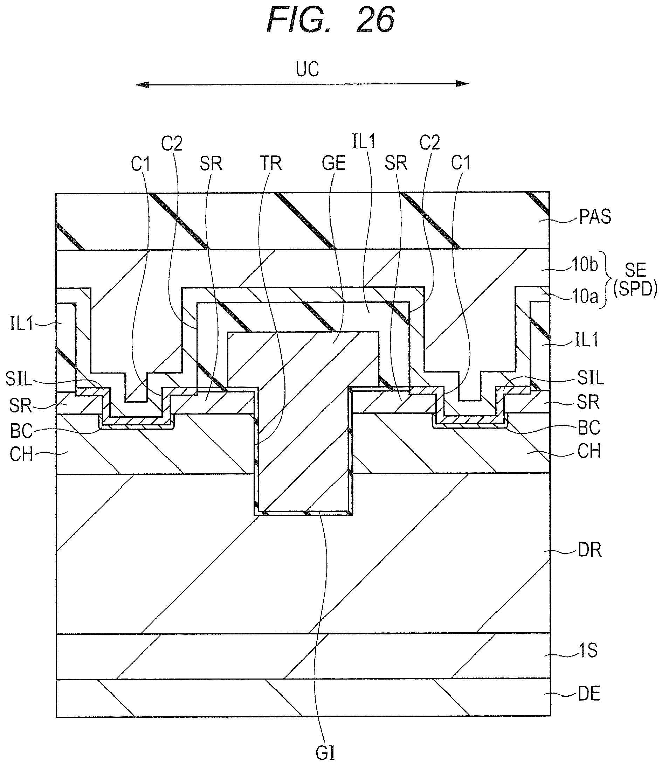

Thereafter, the source electrode SE and the like and the surface protection film PAS are formed inside the contact holes (C1, C2) and over the interlayer insulation film IL1 (FIG. 25), and the drain electrode DE is formed (FIG. 26).

In the semiconductor device of the comparative example where silicidation is performed by RTA twice as described above, a thermal load (700°C×2 min, 1,000°C×2 min) is applied also to the SiC substrate 1S, and C (carbon) in the SiC substrate segregates and a thin film of C (carbon) is possibly generated in the contact region. Particularly, because the SiC substrate is a compound where Si and C is 1:1, C (carbon) is liable to be segregated by a heat treatment. Such segregation of C (carbon) itself causes increase of the contact resistance, exfoliation is liable to occur at the thin film section of C (carbon), and the silicide film peels off for example to cause a contact failure.

On the other hand, according to the present embodiment, as described above, segregation of C (carbon) within the SiC substrate can be suppressed, and increase of the contact resistance and the contact failure described above can be suppressed. Therefore, excellent contact characteristic can be secured.

In addition, in such RTA as performed in the comparative example, the entire SiC substrate 1S becomes hot, and C (carbon) possibly segregates. Therefore, a thermal load is applied not only to the vicinity of the contact hole but also to other regions for example the vicinity of the trench TR and the like, and a problem caused by the thermal load possibly occurs. On the other hand, according to the present embodiment, because the laser goes through the SiC substrate (a portion including SiC) and does not raise the temperature of the SiC substrate itself, segregation of C (carbon) in the vicinity of the trench TR largely involved in the transistor characteristics can be suppressed. Therefore, the transistor characteristics can be improved.

Also, according to the present embodiment, it is not necessary to introduce a film for suppressing segregation of C (carbon) (the Ti film of the comparative example) in the metal film MT, and a metal film (a Ni film and the like) of a single layer for example can be used. For example, as the metal film MT, it is not necessary to use a three layered film of Ni film/Ti film/Ni film, and a single layer film of the Ni film can be used. The film thickness of the metal film MT (Ni film here) can be adjusted within a range of 10 nm or more and 100 nm or less. Thus, the step for manufacturing a semiconductor device can be simplified, and the material cost can be reduced.

Also, according to the present embodiment, by laser annealing of one time, a silicidation reaction can be made to progress sufficiently, and metal silicide with a large composition ratio of Si can be formed. In other words, metal silicide in a more stable phase and having high thermal resistance and high electro-conductivity can be formed. For example, by laser annealing of one time, the silicide film SIL including not Ni₂Si but NiSi can be formed.

Also, as described below, in laser annealing, the heat treatment temperature and the heat treatment time can be adjusted easily by adjusting the energy density, spot diameter, number of times of the shot, overlapping rate, pulse width, and the like. Thus, the degree of silicidation by laser annealing of one time can be adjusted easily.

### [Method for irradiating laser to wafer]

Next, a laser used in the present embodiment will be explained.

As a laser used in the present embodiment, a laser going through SiC and absorbed by metal can be used suitably. As the metal, a metal film for a silicide film can be cited. Also, a laser absorbed by metal is absorbed also by a silicide compound of the metal. As the metal, Ni, Ti, W, Mo, Ta, V, and the like can be cited.

As a laser used in the present embodiment, a laser with the wavelength of 527 nm using a YLF crystal doped with Nd can be used. Also, a laser with the wavelength of 532 nm using a YAG crystal doped with Nd can be used. Further, as described above, it is preferable that the wavelength of the laser used in the present embodiment is within the range of 455 nm-597 nm.

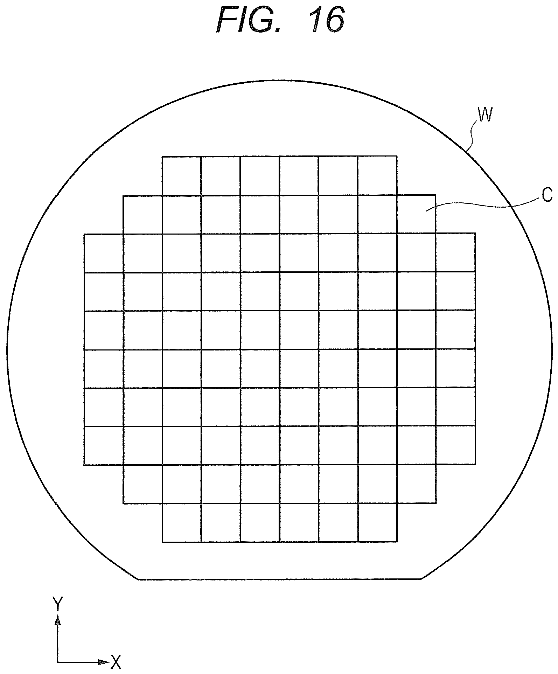

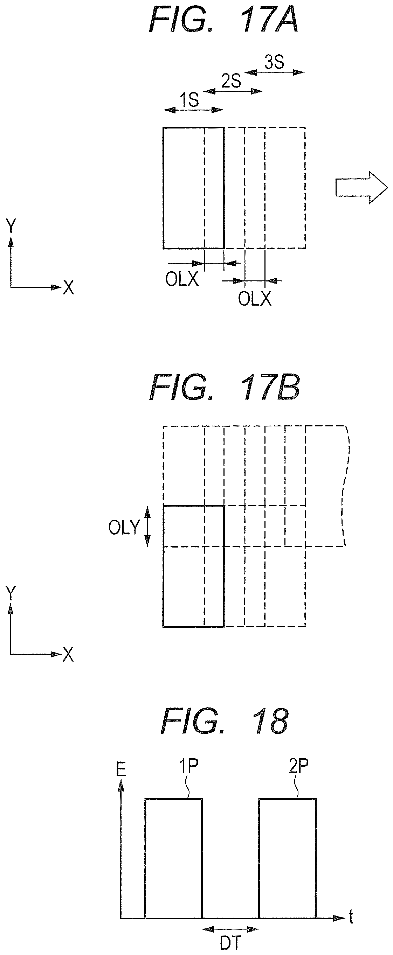

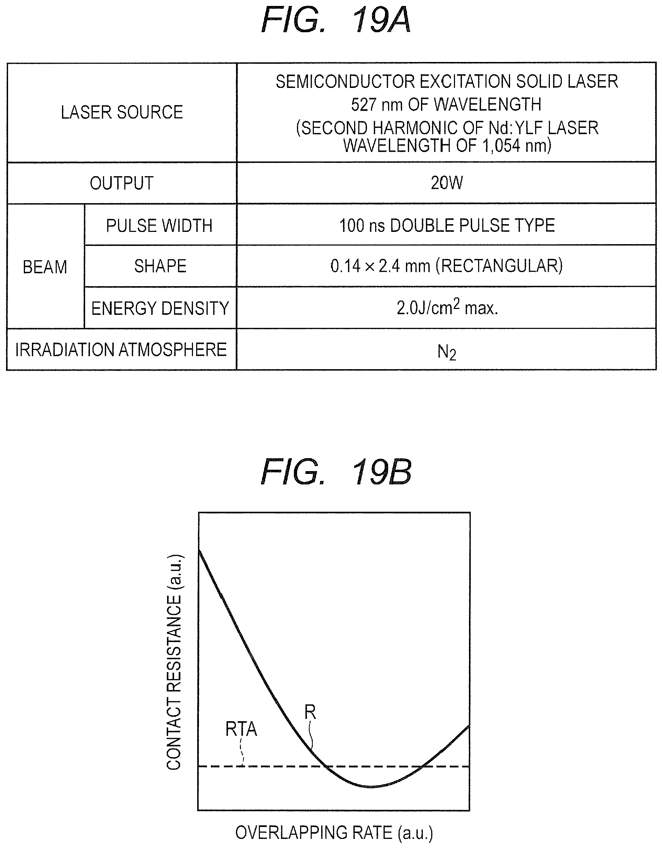

Furthermore, although there is no limitation in a method for irradiating a laser, a laser can be irradiated to the SiC substrate as follows for example. FIG. 16 is a plan view that shows a wafer including a SiC substrate. FIG. 17 is a plan view that shows the shots of the laser irradiated successively. FIG. 18 is a drawing that shows a waveform of a laser of the double pulse type. FIG. 19A is a drawing that shows an example of the laser irradiation condition. FIG. 19B is a drawing that shows the relation between the overlapping rate of a laser and the contact resistance.

FIG. 16 is a plan view that shows a wafer including a SiC substrate. As shown in FIG. 16, a wafer W is a thin plate having a generally circular shape. The wafer W includes chip regions C having a generally rectangular shape.

For example, in irradiating a laser, a laser having a predetermined beam shape is irradiated (scanned) successively from the end of the wafer W. In concrete terms, a laser having a generally rectangular beam shape is irradiated successively to the left direction (X-direction) from the end in the bottom right in the drawing of the generally rectangular chip regions C of the wafer W.
After irradiation of the first line finishes, irradiation is shifted in the upward direction (Y-direction) in the drawing, and irradiation of the second line is performed. By repeating such irradiation, a laser can be irradiated to the generally rectangular chip regions C of the wafer W. That is, the SiC substrate (the wafer W) can be subjected to laser annealing. In such laser annealing, there is a case that a laser irradiated mark remains in the wafer W and the chip region C.

Also, as shown in FIG. 17A, when a laser is irradiated successively in X-direction or Y-direction, the next shot may be irradiated so as to overlap with the previous shot. Further, as shown in FIG. 17B, a laser may be irradiated so that the irradiation region of the first line and the irradiation region of the second line overlap mutually. The degree of overlapping is called an overlapping rate. OLX shows an overlapping region in X-direction, and OLY shows an overlapping region in Y-direction. The overlapping rate is shown by a rate (%) to the beam shape (beam irradiation region) with respect to each direction. For example, when a laser is irradiated to be shifted in X-direction so that 2/3 overlaps with the previous shot, the overlapping rate becomes 66%.

Also, as a laser, a pulse laser can be used. The width of the pulse is 100 ns for example.

Further, it is also possible to use a laser of a double pulse type. The double pulse type is a method for irradiating two pulses from two laser irradiation units while shifting the irradiation timing by a predetermined delay time. As shown in FIG. 18, after a delay time DT from irradiation of a first pulse 1P, a second pulse 2P is irradiated to a same position. The horizontal axis of FIG. 18 represents time (t), and the vertical axis represents energy (E).

For example, when a laser is irradiated in X-direction and Y-direction with the overlapping rate of 66% using the double pulse type, shots of 18 times in total of 2×3×3 come to be irradiated. Thus, according to the laser annealing, the beam shape, pulse width (irradiation time), number of times of the shot, and the like can be adjusted easily, the thermal energy imparted to the SiC substrate (wafer) can be adjusted easily, and adjustment of the heating temperature becomes easy. It is a matter of course that adjustment of the thermal energy by the energy density correlated with the intensity of the laser beam can be easily performed also.

As shown in FIG. 19A, a semiconductor excitation solid laser with the wavelength of 527 nm (a second harmonic of Nd:YLF laser wavelength of 1,054 nm) is used as a laser source, and the output is made 20 W. A double pulse beam with the pulse width of 100 ns is used. The beam shape is a rectangular shape of 0.14×2.4 mm, and the energy density is made 2.0 J/cm². The irradiation atmosphere of the laser is the nitrogen atmosphere. The overlapping rate in X-direction and Y-direction can be adjusted respectively within a range of less than 100%.

When the overlapping rate in X-direction and Y-direction was changed and the contact resistance was measured in a condition shown in FIG. 19A, a graph shown in FIG. 19B was obtained. The horizontal axis of the graph represents the overlapping rate [a. u.], and the vertical axis represents the contact resistance [a. u.]. As shown in the graph, the contact resistance is reduced as the overlapping rate increases, and the contact resistance could be reduced compared to the case of RTA shown by a broken line. Particularly, in a range of 66%-95% of the overlapping rate, the contact resistance could be reduced compared to the case of RTA. Also, the example shown in FIG. 19A is an example only, and the irradiation condition of a laser is not limited to it. Further, the range of the overlapping rate shown in FIG. 19B is also an example. As described above, peeling off of a thin film of carbon (C) in the contact region, deterioration of other portions of the transistor, and so on are suppressed in the present embodiment compared to the case of RTA, and the effects in the present embodiment are not to be limited to the range of 66%-95% of the overlapping rate described above.

Thus, in laser annealing, the heat treatment temperature and the heat treatment time can be adjusted easily by adjusting the energy density, beam shape (spot diameter), number of times of the shot, overlapping rate, pulse width, and the like. Also, as the laser annealing, it is preferable that the thermal load of one shot is (1,000°C-1,500°C)×100 ns or less.

### (Second embodiment)

Although laser annealing of one time was performed as a heat treatment in forming a silicide film (a heat treatment for silicidation) in the first embodiment, it is also possible to perform this heat treatment in 2 steps and to combine RTA and laser annealing.

### [Explanation of structure]

Because the configuration of the semiconductor device of the present embodiment is same to that of the first embodiment (FIG. 1), explanation thereof will be omitted. Also, the operation of the semiconductor device of the present embodiment is similar to that of the case of the first embodiment.

### [Explanation of manufacturing method]

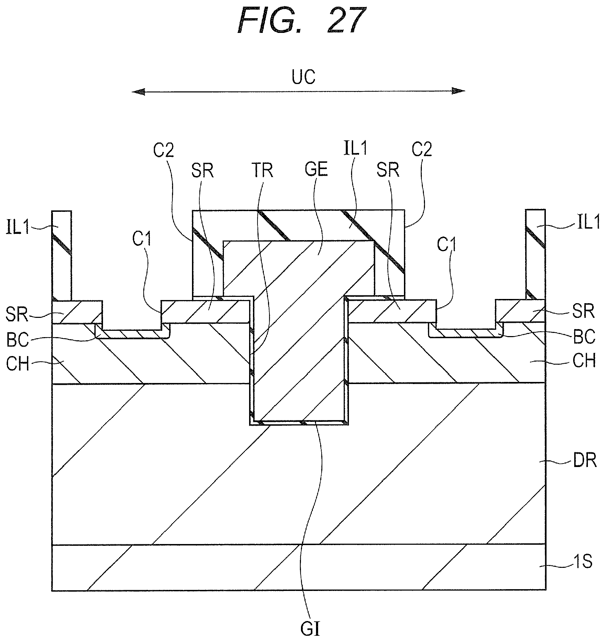

Referring to FIG. 27-FIG. 33, a method for manufacturing a semiconductor device of the present embodiment will be explained. FIG. 27-FIG. 33 are cross-sectional views that show a step for manufacturing the semiconductor device of the present embodiment. Also, with respect to steps similar to those of the case of the first embodiment, detailed explanation thereof will be omitted.

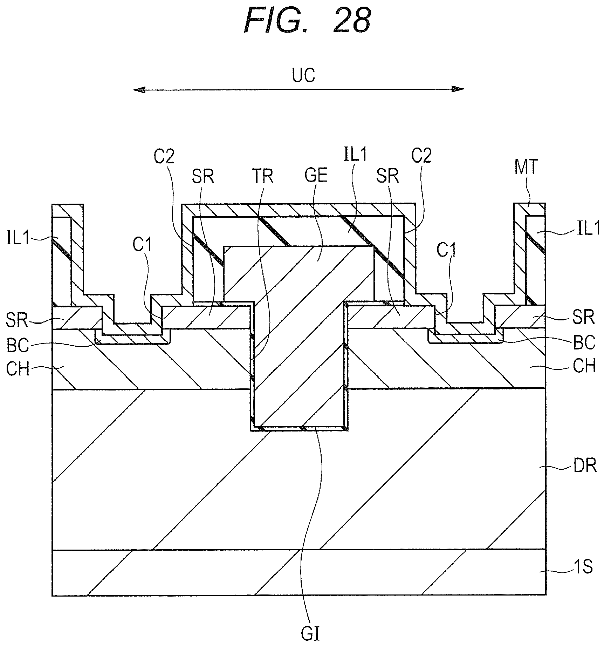

As shown in FIG. 27, the SiC substrate 1S is provided in which the body contact region BC below the contact holes (C1, C2) of the SiC substrate 1S and a part of the source regions SR on both sides of the body contact region BC are exposed. Also, the forming steps up to the above are similar to those of the first embodiment (refer to FIG. 4-FIG. 9). Over the body contact region BC of the SiC substrate 1S and a part of the source regions SR on both sides of the body contact region BC, the silicide film SIL is formed as shown in FIG. 28-FIG. 31.

First, as shown in FIG. 28, a Ni film, a Ti film, and a Ni film for example are layered successively as the metal film (the metal film for the silicide film) MT inside the contact holes (C1, C2) and over the interlayer insulation film IL1 using the sputtering method and the like. Thus, a portion over the body contact region BC and a part of the source regions SR on both sides of the body contact region BC is covered by the metal film MT (Ni film/Ti film/Ni film). By sandwiching the Ti film within the Ni films thus, segregation of C (carbon) within the SiC substrate can be suppressed.

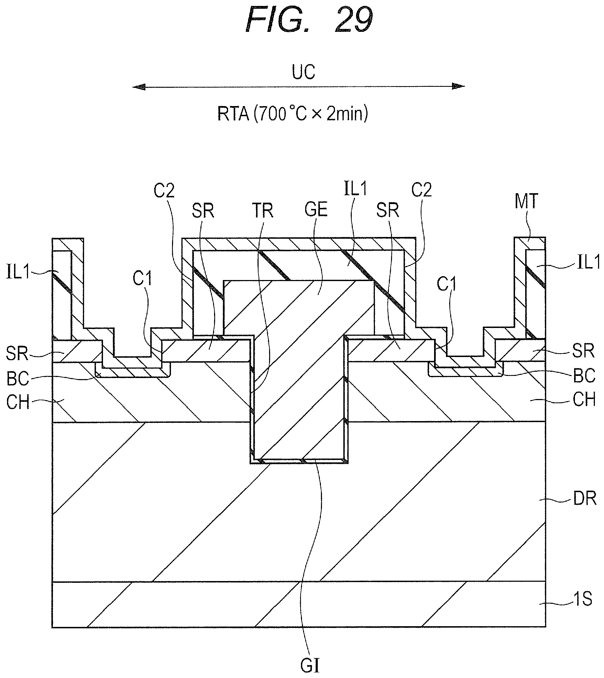

Next, as shown in FIG. 29, the SiC substrate 1S is subjected to the first heat treatment. As the first heat treatment, RTA is performed. For example, the SiC substrate 1S is subjected to a heat treatment for 2 minutes (min) at approximately 700°C within an inert gas atmosphere. By performing the first heat treatment, the metal-rich silicide film SIL for example is formed. For example, when a three layered film of Ni film/Ti film/Ni film is used as the metal film MT, the silicide film SILa including Ni₂Si is formed. Also, NiSi becomes a more stable phase compared to this Ni₂Si.

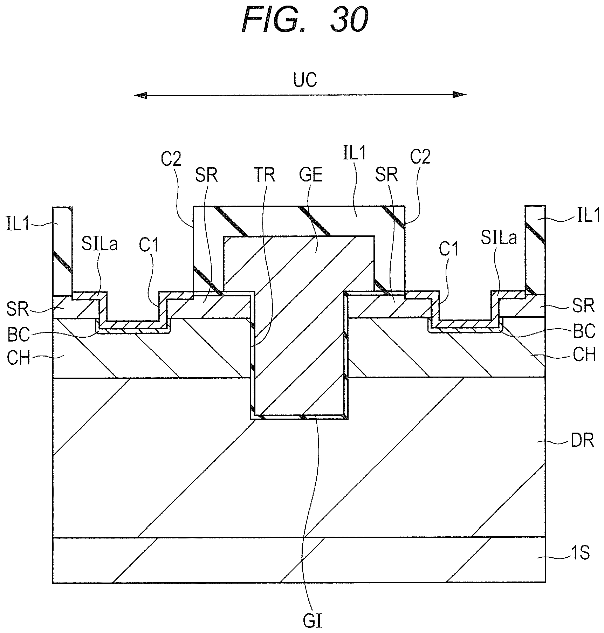

Next, as shown in FIG. 30, the unreacted metal film MT is removed. The unreacted metal film MT is removed using a sulfuric acid or SPM (compound liquid of sulfuric acid and hydrogen peroxide solution) and the like for example. Thus, the silicide film SILa remains over the body contact region BC and a part of the source regions SR on both sides of the body contact region BC.

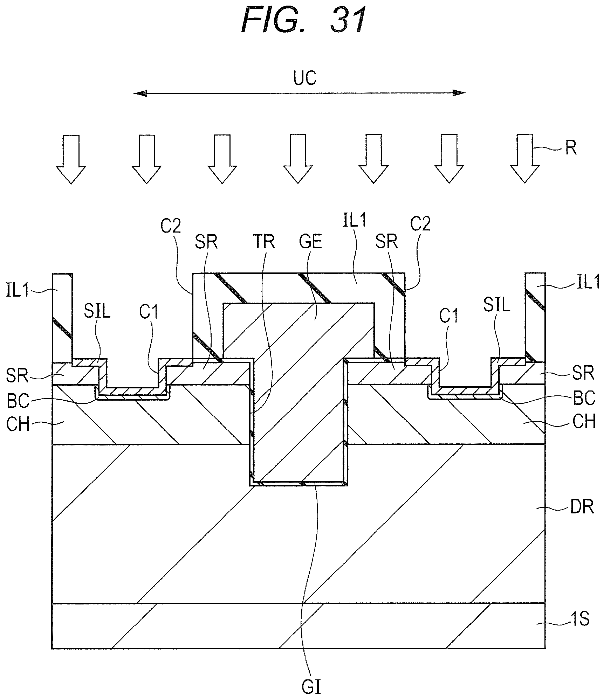

Next, as shown in FIG. 31, the SiC substrate 1S is subjected to the second heat treatment. As the second heat treatment, laser annealing is performed. For example, similarly to the case of the first embodiment, the laser R with the wavelength of 527 nm is irradiated to the SiC substrate 1S. At this time, because the metal film MT has been removed, only a portion of the silicide film SILa is heated selectively. Further, although this laser R with the wavelength of 527 nm is absorbed by the silicide film (SILa), the laser R goes through the SiC substrate 1S. Thus, it is possible that the laser R goes through the SiC substrate without raising the temperature of the SiC substrate and is absorbed by the silicide film (SILa) to generate the heat. By this heating, silicidation progresses, and, for example, the metal-rich silicide film SILa becomes the silicon-rich silicide film SIL. Here, the silicide film SILa including Ni₂Si becomes the silicide film SIL including NiSi. Because NiSi is a phase more stable compared to Ni₂Si, NiSi has high thermal resistance and has higher electro-conductivity compared to Ni₂Si.

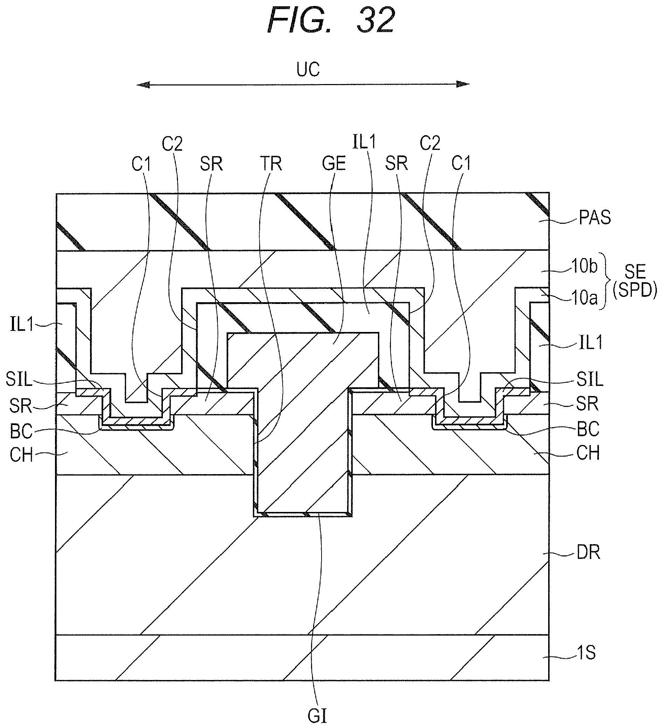

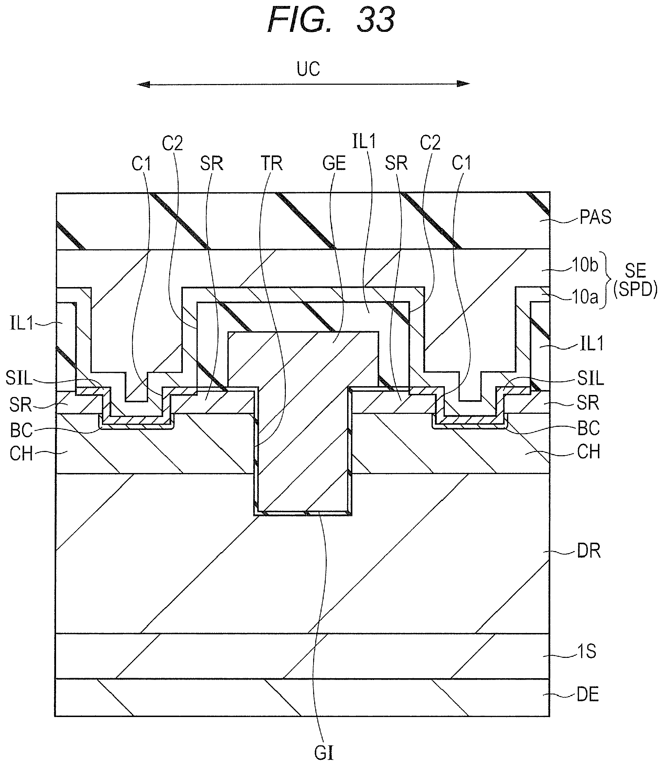

Thereafter, the source electrode SE and the like and the surface protection film PAS are formed inside the contact holes (C1, C2) and over the interlayer insulation film IL1 (FIG. 32), and the drain electrode DE is formed (FIG. 33). The source electrode SE, the surface protection film PAS, and the drain electrode DE can be formed similarly to the case of the first embodiment.

As described above, in the present embodiment, the heat treatment for silicidation was performed in two steps, RTA that was annealing at a comparatively low temperature (below 1,000°C) was performed as the first heat treatment, the metal film MT for unreacted silicide film was thereafter removed, and laser annealing was performed as the second heat treatment. Thus, the thermal load to the SiC substrate 1S can be reduced compared to the case explained in the first embodiment for example. Also, because laser annealing was performed after removing the metal film MT for unreacted silicide film, the silicide film SILa (contact region) can be selectively heated without heating the entire surface of the SiC substrate, and therefore the thermal load at the surface of the SiC substrate can be reduced.

Therefore, in the present embodiment also, segregation of C (carbon) from the SiC substrate can be suppressed. Also, as explained in detail in the first embodiment, excellent contact characteristics can be secured, and the transistor characteristics can be improved.

Further, by introducing a film for suppressing segregation of C (carbon) (the Ti film in the comparative example) into the metal film MT and using a three layered film of Ni film/Ti film/Ni film for example, even when the first heat treatment is made RTA, segregation of C (carbon) in this heat treatment can be suppressed. Also, because the second heat treatment is laser annealing, temperature rise of the SiC substrate 1S can be suppressed, and therefore segregation of C (carbon) can be suppressed.

Further, according to the present embodiment, by laser annealing of the second heat treatment, silicidation reaction can be made to progress sufficiently, and metal silicide with a large composition ratio of Si can be formed. In other words, metal silicide in a more stable phase and having high thermal resistance and high electro-conductivity can be formed. For example, by laser annealing of the second heat treatment, the silicide film SIL including not Ni₂Si but NiSi can be formed.

Also, in laser annealing, the heat treatment temperature and the heat treatment time can be adjusted easily by adjusting the energy density, beam shape (spot diameter), number of times of the shot, overlapping rate, pulse width, and the like, and the degree of silicidation can be adjusted easily.

### (Third embodiment)

Although the heat treatment in forming the silicide film (the heat treatment for silicidation) was performed in two steps, RTA was performed as the first heat treatment, and laser annealing was performed as the second heat treatment in the second embodiment, both of the first heat treatment and the second heat treatment may be laser annealing.

### [Explanation of structure]

Because the configuration of the semiconductor device of the present embodiment is a configuration similar to that of the first embodiment (FIG. 1), explanation thereof will be omitted. Also, the operation of the semiconductor device of the present embodiment is similar to the case of the first embodiment.

### [Explanation of manufacturing method]

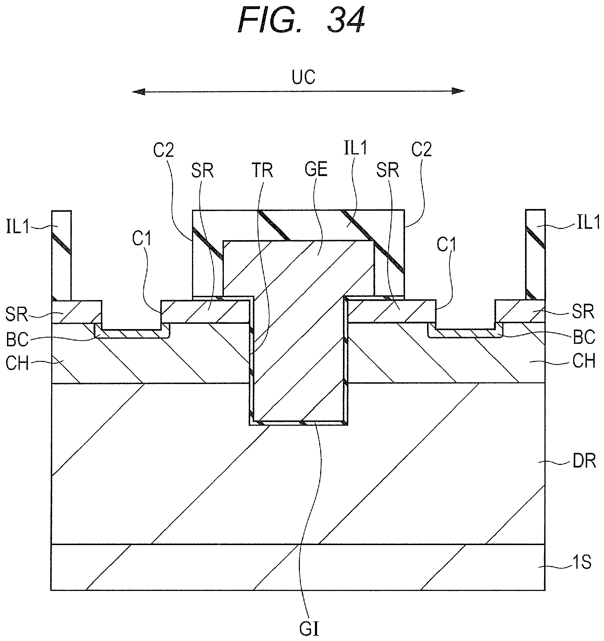

Referring to FIG. 34-FIG. 40, a method for manufacturing a semiconductor device of the present embodiment will be explained. FIG. 34-FIG. 40 are cross-sectional views that show a step for manufacturing the semiconductor device of the present embodiment. Also, with respect to steps similar to those of the case of the first embodiment, detailed explanation thereof will be omitted.

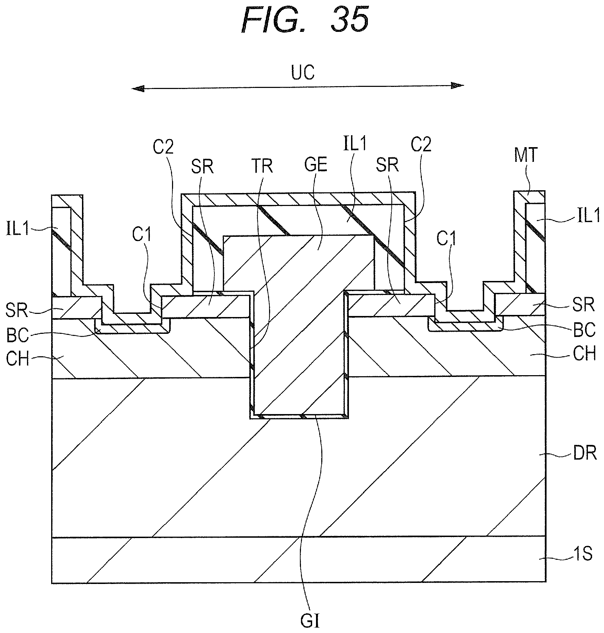

As shown in FIG. 34, the SiC substrate 1S is provided in which the body contact region BC below the contact holes (C1, C2) of the SiC substrate 1S and a part of the source regions SR on both sides of the body contact region BC are exposed. Also, the forming steps up to the above are similar to those of the first embodiment (refer to FIG. 4-FIG. 9). Over the body contact region BC of the SiC substrate 1S and a part of the source regions SR on both sides of the body contact region BC, the silicide film SIL is formed as shown in FIG. 35-FIG. 38.

First, as shown in FIG. 35, Ni films for example are layered as the metal film (the metal film for the silicide film) MT inside the contact holes (C1, C2) and over the interlayer insulation film IL1 using the sputtering method and the like. Thus, a portion over the body contact region BC and a part of the source regions SR on both sides of the body contact region BC is covered by the metal film MT (Ni film).

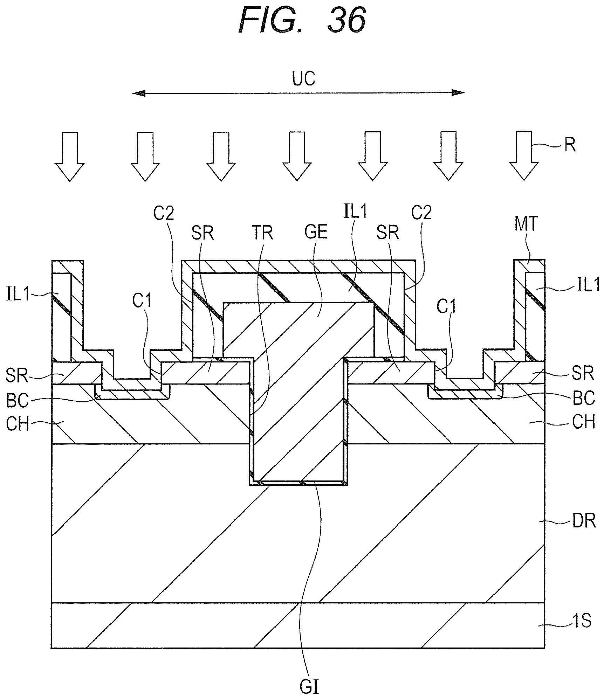

Next, as shown in FIG. 36, the SiC substrate 1S is subjected to the first heat treatment. As the first heat treatment, laser annealing is performed. For example, similarly to the case of the first embodiment, the laser R having a pulse with the wavelength of 527 nm is irradiated to the SiC substrate 1S. Also, the laser R having the wavelength of 527 nm is absorbed by the metal film MT, but goes through the SiC substrate. Thus, it is possible that the laser goes through the SiC substrate without raising the temperature of the SiC substrate and is absorbed by the metal film MT to generate the heat. By this heating, silicidation progresses, and the metal-rich silicide film SIL for example is formed. For example, when a Ni film is used as the metal film MT, the silicide film SILa including Ni₂Si is formed. Also, it is allowed that silicidation progresses by this laser annealing and a silicide film similar to NiSi is formed.

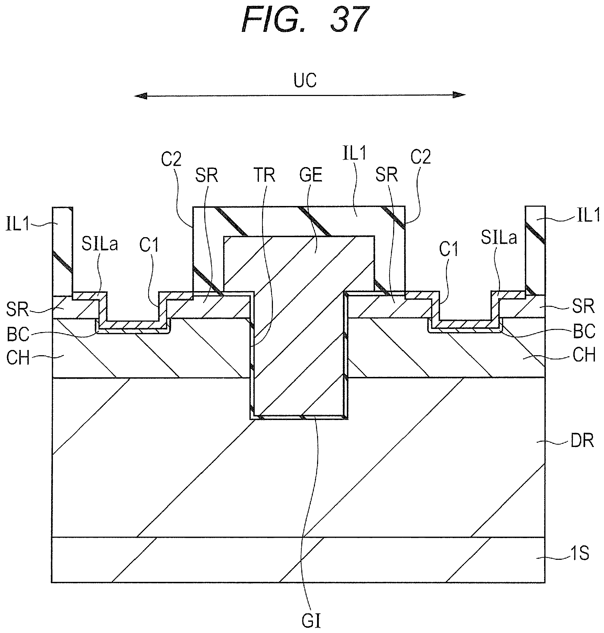

Next, as shown in FIG. 37, unreacted metal film MT is removed. The unreacted metal film MT is removed using a sulfuric acid or SPM (compound liquid of sulfuric acid and hydrogen peroxide solution) and the like for example. Thus, the silicide film SILa remains over the body contact region BC and a part of the source regions SR on both sides of the body contact region BC.

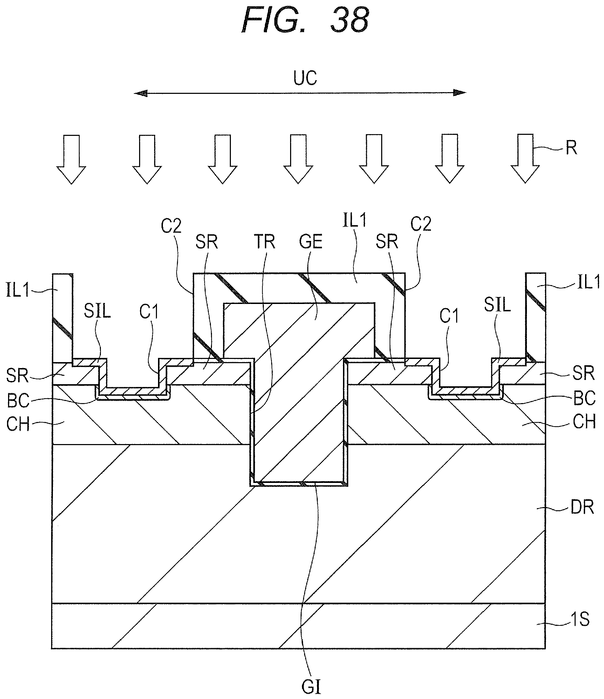

Next, as shown in FIG. 38, the SiC substrate 1S is subjected to the second heat treatment. As the second heat treatment, laser annealing is performed. For example, similarly to the case of the first embodiment, the laser R with the wavelength of 527 nm is irradiated to the SiC substrate 1S. At this time, because the metal film MT has been removed, only a portion of the silicide film (SILa) is heated selectively. Further, although this laser R with the wavelength of 527 nm is absorbed by the silicide film (SILa), the laser R goes through the SiC substrate 1S. Thus, it is possible that the laser R goes through the SiC substrate without raising the temperature of the SiC substrate and is absorbed by the silicide film (SILa) to generate the heat. By this heating, silicidation progresses, and, for example, the metal-rich silicide film SILa becomes the silicon-rich silicide film SIL. Here, the silicide film SILa including Ni₂Si becomes the silicide film SIL including NiSi. Because NiSi is a phase more stable compared to Ni₂Si, NiSi has high thermal resistance and has higher electro-conductivity compared to Ni₂Si.

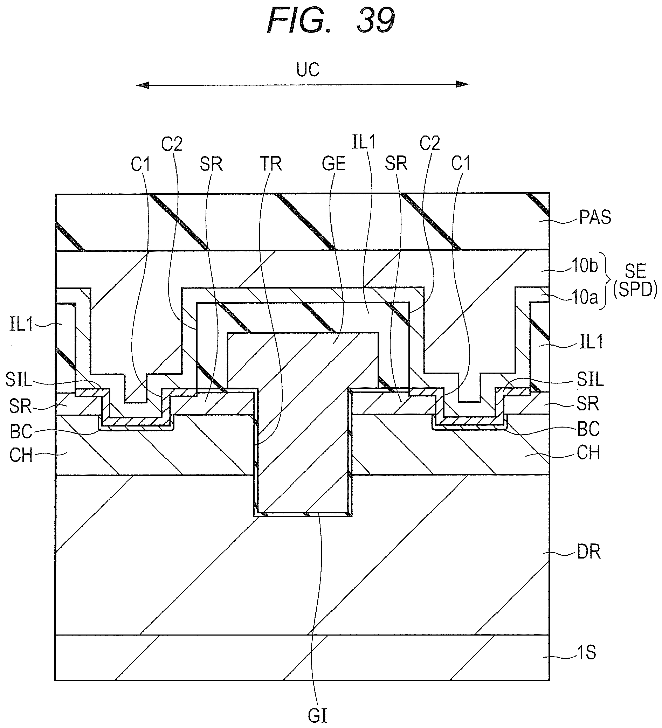

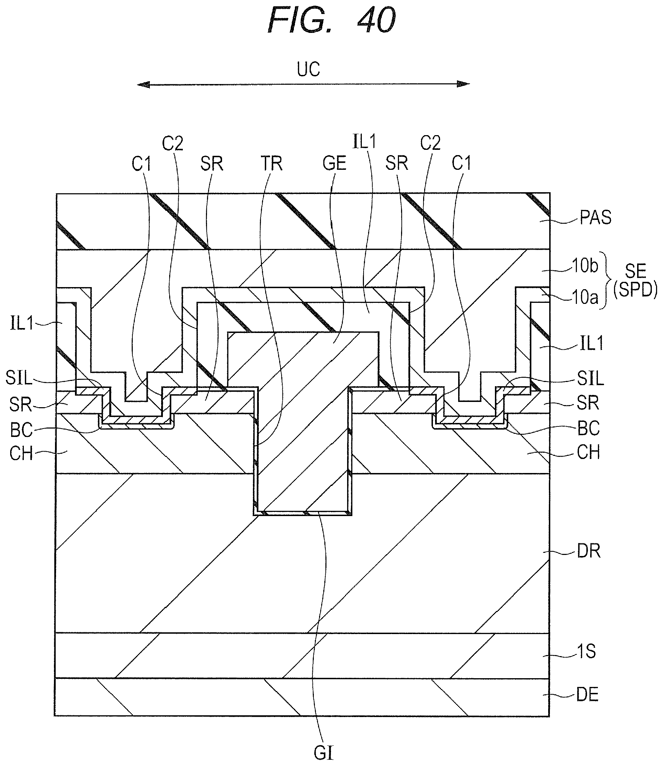

Thereafter, the source electrode SE and the like and the surface protection film PAS are formed inside the contact holes (C1, C2) and over the interlayer insulation film IL1 (FIG. 39), and the drain electrode DE is formed (FIG. 40). The source electrode SE, the surface protection film PAS, and the drain electrode DE can be formed similarly to the case of the first embodiment.

As described above, in the present embodiment, the heat treatment for silicidation was performed in two steps, and laser annealing was performed as the first and second heat treatment. Thus, the thermal load to the SiC substrate 1S can be reduced compared to the case of the comparative example explained in the first embodiment for example. Also, because laser annealing was performed after removing the metal film MT for unreacted silicide film in the second treatment, the silicide film SILa (contact region) can be selectively heated without heating the entire surface of the SiC substrate, and therefore the thermal load at the surface of the SiC substrate can be reduced.

Further, according to the present embodiment, by laser annealing of the second heat treatment, silicidation reaction can be made to progress sufficiently, and metal silicide with a large composition ratio of Si can be formed. In other words, metal silicide in a more stable phase and having high thermal resistance and high electro-conductivity can be formed. For example, by laser annealing of the second heat treatment, the silicide film SIL including not Ni₂Si but NiSi can be formed.

Also, in laser annealing, the heat treatment temperature and the heat treatment time can be adjusted easily by adjusting the energy density, beam shape (spot diameter), number of times of the shot, overlapping rate, pulse width, and the like, and the degree of silicidation can be adjusted easily.

For example, the energy density of the first heat treatment may be made lower than the energy density of the second heat treatment. As an example of the heat treatment, it is possible to perform the first heat treatment by double pulse of 1.7 J/cm² of the energy density, 66% of the overlapping rate, and 0 of the delay time, and to perform the second heat treatment by double pulse of 1.9 J/cm² of the energy density, 66% of the overlapping rate, and 0 of the delay time.

As described above, in the present embodiment also, segregation of C (carbon) from the SiC substrate can be suppressed. Also, as explained in detail in the first embodiment, excellent contact characteristics can be secured, and the transistor characteristics can be improved.

Although the invention achieved by the present inventors has been explained above specifically based on the embodiments, it is needless to mention that the present invention is not limited to the embodiments described above and various alterations are possible within a scope not deviating from the purposes thereof.

For example, although the first-third embodiments were explained with an example of the trench gate type power transistor, there is no limitation in the element formed over the SiC substrate, and a planer type power transistor for example may be used. That is, the present invention is applicable widely to elements including a portion including SiC and required to form a plug and the like over the portion.

## Claims

1. A method for manufacturing a semiconductor device, comprising the steps of:
(a) forming an element on a first surface side of a SiC substrate;
(b) forming an interlayer insulation film over the element;
(c) forming a contact hole where a portion including SiC is exposed to the bottom surface of the contact hole by removing the interlayer insulation film over a configuration section of the element;
(d) forming a metal film containing a first metal over the bottom surface and the side surface of the contact hole and the interlayer insulation film; and
(e) performing a heat treatment to form a silicide film of the first metal at the bottom surface of the contact hole by a silicidation reaction of the metal film and the portion including SiC,
wherein the step (e) is a step for irradiating a laser beam to the first surface side of the SiC substrate.

2. The method for manufacturing a semiconductor device according to claim 1,
wherein the laser beam goes through the portion including SiC and is absorbed by the metal film.

3. The method for manufacturing a semiconductor device according to claim 2,
wherein the wavelength of the laser beam is 455 nm-597 nm.

4. The method for manufacturing a semiconductor device according to claim 2, further comprising the step of:
(f) after the step (e), removing a portion of the metal film unreacted in the silicidation reaction out of the metal film.

5. The method for manufacturing a semiconductor device according to claim 4, further comprising the step of:
(g) after the step (f), forming an electro-conductive film inside the contact hole inclusive of over the silicide film.

6. The method for manufacturing a semiconductor device according to claim 5, further comprising the step of:
between the step (c) and the step (d), forming a semiconductor region by injecting impurity ions to the bottom surface of the contact hole.

7. The method for manufacturing a semiconductor device according to claim 6,
wherein the metal film is a single layer film configured of only a film including the first metal.

8. A method for manufacturing a semiconductor device, comprising the steps of:
(a) forming an element on a first surface side of a SiC substrate;
(b) forming an interlayer insulation film over the element;
(c) forming a contact hole where a portion including SiC is exposed to the bottom surface of the contact hole by removing the interlayer insulation film over a configuration section of the element;
(d) forming a metal film containing a first metal over the bottom surface and the side surface of the contact hole and the interlayer insulation film;
(e) performing a heat treatment to form a first silicide film of the first metal at the bottom surface of the contact hole in the SiC substrate;
(f) removing a portion of a metal film unreacted in the step (e) out of the metal film; and
(g) irradiating a laser beam to the first surface side of the SiC substrate to form a second silicide film of the first metal.

9. The method for manufacturing a semiconductor device according to claim 8,
wherein the heat treatment is infrared lamp annealing.

10. The method for manufacturing a semiconductor device according to claim 9,
wherein the laser beam goes through the portion including SiC and is absorbed by the first silicide film.

11. The method for manufacturing a semiconductor device according to claim 10,
wherein the wavelength of the laser beam is 455 nm-597 nm.

12. The method for manufacturing a semiconductor device according to claim 11, further comprising the step of:
(h) after the step (g), forming an electro-conductive film inside the contact hole inclusive of over the second silicide film.

13. The method for manufacturing a semiconductor device according to claim 12, further comprising the step of:
between the step (c) and the step (d), forming a semiconductor region by injecting impurity ions to the bottom surface of the contact hole.

14. The method for manufacturing a semiconductor device according to claim 10,
wherein the metal film is a layered film of a first film including the first metal and a second film formed over the first film and including a second metal other than the first metal.

15. A method for manufacturing a semiconductor device, comprising the steps of:
(a) forming an element on a first surface side of a SiC substrate;
(b) forming an interlayer insulation film over the element;
(c) forming a contact hole where a portion including SiC is exposed to the bottom surface of the contact hole by removing the interlayer insulation film over a configuration section of the element;
(d) forming a metal film containing a first metal over the bottom surface and the side surface of the contact hole and the interlayer insulation film;
(e) irradiating a laser beam to the first surface side of the SiC substrate to form a first silicide film of the first metal;
(f) removing a portion of a metal film unreacted in the step (e) out of the metal film; and
(g) irradiating a laser beam to the first surface side of the SiC substrate to form a second silicide film of the first metal.

16. The method for manufacturing a semiconductor device according to claim 15,
wherein the laser beam of the step (e) goes through the portion including SiC and is absorbed by the metal film; and
wherein the laser beam of the step (g) goes through the portion including SiC and is absorbed by the first silicide film.

17. The method for manufacturing a semiconductor device according to claim 16,
wherein the wavelength of the laser beam of the step (e) and the step (g) is 455 nm-597 nm.

18. The method for manufacturing a semiconductor device according to claim 16, further comprising the step of:
(h) after the step (g), forming an electro-conductive film inside the contact hole inclusive of over the second silicide film.

19. The method for manufacturing a semiconductor device according to claim 18, further comprising the step of:
between the step (c) and the step (d), forming a semiconductor region by injecting impurity ions to the bottom surface of the contact hole.
